# EUROPEAN PATENT APPLICATION

(11) **EP 4 672 319 A1**
(43) Date of publication of application: **31.12.2025**
(21) Application number: 25173940.5
(22) Date of filing: 02.05.2025
(51) Int. Cl.: H01L 23/15

(54) **METHODS AND SYSTEMS FOR FORMING INTEGRATED CIRCUIT PACKAGES COMPRISING GLASS LAYERS**

(30) Priority: 28.06.2024 US 202418759570
(71) Applicant: INTEL Corporation, Santa Clara, CA 95054 (US)
(72) Inventor: Jimenez, Andrew Matthew, Mesa AZ, 85210 (US); Konchady, Manohar, Chandler AZ, 85248 (US); Mohammadighaleni, Mahdi, Phoenix AZ, 85048 (US); Tanaka, Hiroki, Gilbert AZ, 85295 (US); Zamani, Ehsan, Phoenix AZ, 85044 (US); Bryks, Whitney M., Tempe AZ, 85284 (US); Chen, Haobo, Chandler AZ, 85249 (US); Duan, Gang, Chandler AZ, 85226 (US); Duong, Benjamin T., Phoenix AZ, 85044 (US); Grujicic, Darko, Chandler AZ, 85249 (US); Han, Jung Kyu, Chandler AZ, 85225 (US); Heaton, Thomas S., Gilbert AZ, 85234 (US); Kaviani, Shayan, Phoenix AZ, 85048 (US); Marin, Brandon C., Gilbert AZ, 85234 (US); May, Robert A., Chandler AZ, 85249 (US); Mousavi, Seyyed Yahya, Chandler AZ, 85226 (US); Nie, Bai, Chandler AZ, 85249 (US); Pietambaram, Srinivas Venkata Ramanuja, Chandler AZ, 85249 (US); Shan, Bohan, Chandler AZ, 85226 (US); Stacey, Joshua J., Chandler AZ, 85286 (US); Tavakoli, Elham, Phoenix AZ, 85048 (US); Wang, Yekan, Chandler AZ, 85286 (US); Xie, Zhixin, Chandler AZ, 85249 (US)
(74) Representative: Samson & Partner Patentanwälte mbB

(57) **Abstract**

An apparatus comprising a package substrate, the package substrate comprising a glass layer, a first layer comprising a photo-imageable dielectric (PID) material above the glass layer, a second layer below the glass layer, the second layer comprising the PID material, at least one buildup layer above the first layer, and at least one buildup layer below the second layer.

## Description

### BACKGROUND

A package substrate may be used in an electronic device to provide electrical and mechanical support to integrated circuit components coupled thereto. A package substrate may host a network of conductive traces that connect various components on the surface of the package substrate. The package substrate may also feature conductive pathways (e.g., vias) that traverse the layers of the substrate, enabling connections between different layers of the package substrate. In some instances, a package substrate may provide electrical connection between one or more integrated circuit components and various circuits of a printed circuit board upon which the package substrate is mounted.

### BRIEF DESCRIPTION OF THE DRAWINGS

FIGS. 1 and 2 illustrate various phases of manufacture of package substrates comprising glass cores using an improved reinforcement material, in accordance with any of the embodiments disclosed herein.
FIGS. 3-5 illustrate various phases of manufacture of package substrates comprising glass cores using various improved reinforcement materials, in accordance with any of the embodiments disclosed herein.
FIG. 6 illustrates various phases of manufacture of package substrates comprising glass cores using a liquid polymer to fill gaps, in accordance with any of the embodiments disclosed herein.
FIGS. 7-8 illustrate various phases of manufacture of package substrates comprising glass cores and an epoxy material, in accordance with any of the embodiments disclosed herein.
FIG. 9 illustrates a side cross section of a package with a glass unit panel after singulation, in accordance with any of the embodiments disclosed herein.
FIG. 10 illustrates various phases of manufacture of package substrates comprising glass cores using a photo-imageable dielectric (PID) frame, in accordance with any of the embodiments disclosed herein.
FIG. 11 illustrates various phases of manufacture of package substrates comprising glass cores using a PID frame without an intermediate layer, in accordance with any of the embodiments disclosed herein.
FIGS. 12-14 illustrate various phases of manufacture of package substrates comprising glass cores using a PID and metallic frame, in accordance with any of the embodiments disclosed herein.
FIGS. 15-16 illustrate various phases of manufacture of package substrates comprising glass cores using a non-patterned PID and metallic frame, in accordance with any of the embodiments disclosed herein.
FIG. 17 illustrates top-level views of a unit level PID frame for a glass panel and a unit level PID and metal frame for a glass panel, in accordance with any of the embodiments disclosed herein.
FIG. 18 illustrates an integrated circuit package comprising a glass core, in accordance with any of the embodiments disclosed herein.
FIG. 19 provides a schematic illustration of a cross-sectional view of an example integrated circuit device, in accordance with any of the embodiments disclosed herein.
FIG. 20 is a top view of a wafer and dies that may be included in a microelectronic assembly, in accordance with any of the embodiments disclosed herein.
FIG. 21 is a cross-sectional side view of an integrated circuit device that may be included in a microelectronic assembly, in accordance with any of the embodiments disclosed herein.
FIGS. 22A-22D are perspective views of example planar, FinFET, gate-all-around, and stacked gate-all-around transistors.
FIG. 23 is a cross-sectional side view of an integrated circuit device assembly that may include a microelectronic assembly, in accordance with any of the embodiments disclosed herein.
FIG. 24 is a block diagram of an example electrical device that may include a microelectronic assembly, in accordance with any of the embodiments disclosed herein.

### DETAILED DESCRIPTION

In some implementations, a package substrate may comprise a glass core sandwiched between buildup layers. Recently, glass cores have been explored as alternatives to organic resin-based cores (e.g., cores based on Ajinomoto Buildup Film (ABF)). For a variety of reasons, glass is expected to improve the mechanical and electrical performance of semiconductor substrate packages over other core materials. For example, glass is considered more rigid than organic resin-based materials and has several advantages such as excellent thermal properties, a low coefficient of thermal expansion (CTE), high electrical insulation, chemical resistance, optical transparency, and compatibility with advanced semiconductor properties. In some instances, glass cores may facilitate transmission of high frequency signals within the package. As another example, glass cores also allow improved coplanarity over cores made from organic materials.

Implementing a glass core can introduce a variety of technical challenges and reliability issues. A major challenge for widespread adoption of glass cores is the susceptibility of the glass to damage due to mechanical and/or thermal stresses. For example, glass core substrates with a high number of buildup layers have a high risk of glass splitting in the core due to internal residual buildup stress as well as CTE mismatch between the core and buildup layers. During a depaneling or singulation step, any defects introduced during any of the upstream process steps in the glass core material coupled w/ high CTE mismatch between the glass core and buildup material can easily lead to glass separation. The risk of glass splitting is especially high for thicker core substrates.

As another example, contact with the glass by various toolsets in the line can lead to minor defects along the glass edge, eventually leading to breaks in the glass. Upgrading equipment and overhauling the process flow in order to alleviate these risks to improve yield can be costly.

Crack formation and propagation in glass compromises the structural integrity of glass, making microelectronic assemblies with glass cores particularly prone to failure over time. Embodiments of the present disclosure relate to various techniques, as well as to related devices and methods, for alleviating (e.g., mitigating or reducing) crack formation and propagation in glass panels used to form glass cores or other glass structures used in integrated circuit packages.

A hybrid reconstitution process may include providing a protective edge (referred to herein as a frame) around the glass panel while simultaneously encapsulating the glass panel in a standard use dielectric material. This allows fragile glass core panels to be used within standard organic panel line toolsets. However, various challenges may be associated with manufacturing of the organic frame and placement of the glass within the frame. For example, manufacturing the organic frame may increase the cost or difficulty of the manufacturing process and require an additional tool. Furthermore, accurate placement of the glass within the frame may also be difficult and require additional tools or materials.

Moreover, the hybrid reconstitution process may leave a fragile gap between the glass panel and the frame (e.g., which may comprise an organic material, such as copper clad laminate) around the glass panel, which needs to be reinforced to survive further processing. A buildup layer material, such as Ajinomoto buildup film (ABF) may be placed in the gap. However, buildup layer materials such as ABF may be relatively brittle and may be subject to cracking during subsequent process steps. Accordingly, a reinforcement material may be placed in the footprint of the gap (e.g., over the gap and/or below the gap). For example, a reinforcement strip comprising glass cloth prepreg (GCP) or resin coated copper (RCC) may be used to provide reinforcement across the gap.

Various embodiments of the present disclosure provide improved protection of glass panels during a manufacturing process through improved reinforcement materials proximate gaps between a frame and a glass panel. Some embodiments of the present disclosure may include encapsulating the glass panel with a low CTE epoxy material (e.g., a graphene doped epoxy material that has excellent mechanical & thermal properties).

In some embodiments, instead of using an ex situ hybrid process in which the organic frame is attached to the glass, an in situ process may be used in which the frame is plated directly onto the glass panel. In various embodiments, the frame may have a high modulus (e.g., 20 to 70 GPa, or even greater than 80 GPa) providing superior protection to the glass panel.

Various embodiments may provide one or more advantages, such as increased protection against glass cracking during the manufacturing process, reduced manufacturing cost, improved yield, or reduced complexity in manufacturing processes.

As used herein, the term "glass" (e.g., when used in combination with a structure, such as a panel, subpanel, quarter panel, unit panel, core, substrate, or the like) may refer to a layer (e.g., a glass layer), a portion of a glass layer, or other structure of any glass material such as quartz, silica, fused silica, silicate glass (e.g., borosilicate, aluminosilicate, alumino-borosilicate), soda-lime glass, soda-lime silica, borofloat glass, lead borate glass, photosensitive glass, non-photosensitive glass, or ceramic glass.

In particular, the glass may be bulk glass or a solid volume/layer of glass, as opposed to, e.g., materials that may include particles of glass, such as glass fiber reinforced polymers (e.g., substrates/boards constructed of glass fibers and an epoxy binder). Such glass materials are typically non-crystalline, often transparent, amorphous solids. In some embodiments, the glass may be an amorphous solid glass layer. In some embodiments, the glass may include a material comprising silicon and oxygen, as well as any one or more of aluminum, boron, magnesium, calcium, barium, tin, sodium, potassium, strontium, phosphorus, zirconium, lithium, titanium, and zinc.

In some embodiments, the glass may include a material, e.g., any of the materials described above, with a weight percentage of silicon being at least about 0.5%, e.g., between about 0.5% and 50%, between about 1% and 48%, or at least about 23%. For example, if the glass is fused silica, the weight percentage of silicon may be about 47%. In some embodiments, the glass may include a material having at least 23% silicon and/or at least 26% oxygen by weight, and, in some further embodiments, the glass may further include at least 5% aluminum by weight.

In some embodiments, the glass may include any of the materials described above and may further include one or more additives such as Al₂O₃, B₂O₃, MgO, CaO, SrO, BaO, SnO₂, Na₂O, K₂O, SrO, P₂O₃, ZrO₂, Li₂O, Ti, and Zn.

In some embodiments, the glass may be a layer of glass that does not include an organic adhesive or an organic material. The glass may be distinguished from, for example, the "prepreg" or "RF4" core of a PCB substrate which typically includes glass fibers embedded in a resinous organic material such as an epoxy.

In such traditional cores/substrates including glass fibers and epoxy, the diameter of the glass fibers is generally in the range of 5 microns to 200 microns. In contrast, in some embodiments, a glass structure (e.g., core, layer, or substrate) may be about 10 millimeters on a side to about 250 millimeters on a side (e.g., 10 millimeters x 10 millimeters to 250 millimeters x 250 millimeters). In some embodiments, a cross-section of the glass structure in an x-z plane, a y-z plane, and/or an x-y plane of an example coordinate system, may be substantially rectangular. In at least some such embodiments, in the top-down view of a glass structure (e.g., the x-y plane), the glass structure may comprise a solid layer of glass substantially rectangular in shape and may have a first length in a range of 10 millimeters to 250 millimeters, and a second length in a range of 10 millimeters to 250 millimeters, the first length perpendicular to the second length. A thickness of the glass structure (e.g., a dimension measured along the z-axis) may be in a range of about 50 microns to 1.4 millimeters. In some embodiments, the glass structure may be a glass core substrate having a thickness in a range of about 50 microns to 1.4 millimeters. In various embodiments, a multi-layer glass substrate (e.g., a coreless substrate) may be used in a package, wherein a glass layer of the substrate has a thickness in a range of about 25 microns to 50 microns. In some embodiments, the glass structure may be a layer of glass comprising a rectangular prism volume. In some such embodiments, the rectangular prism volume may have a first side and a second side perpendicular to the first side, the first side having a length in a range of 10 millimeters to 250 millimeters and the second side having a length in a range of 10 millimeters to 250 millimeters. In some embodiments, the glass structure may be a rectangular prism volume with sections (e.g., vias) removed and filled with at least one other material (e.g., metal) e.g., through glass vias (TGVs). In some embodiments, the glass structure may be a layer of glass having a thickness in a range of 50 microns to 1.4 millimeters, a first length in a range of 10 millimeters to 250 millimeters, and a second length in a range of 10 millimeters to 250 millimeters, the first length perpendicular to the second length.

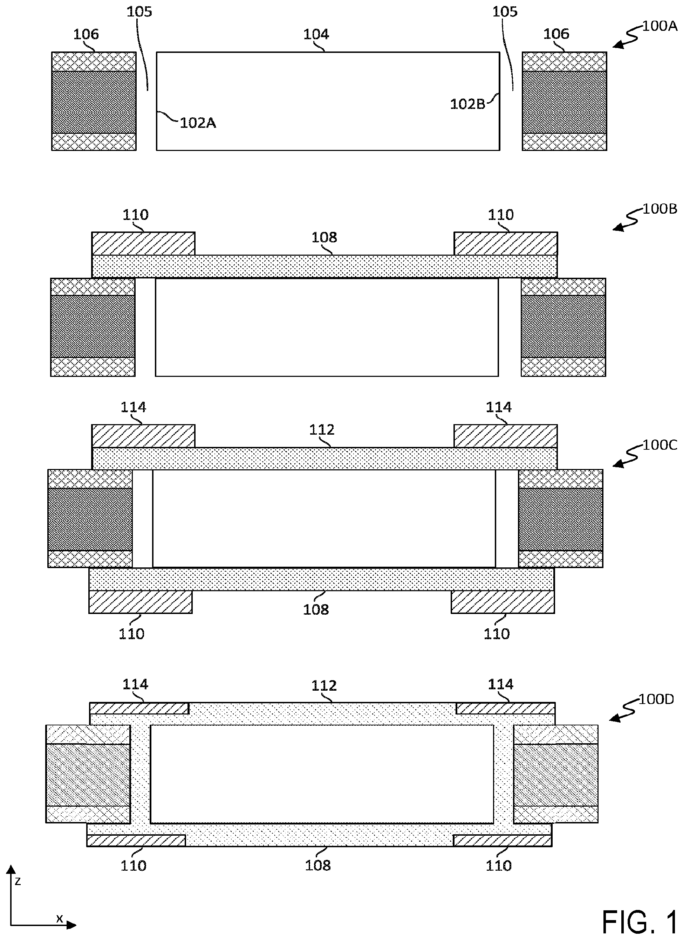

FIG. 1 illustrates various phases 100A-D of manufacture of package substrates comprising glass cores using an improved reinforcement material 110, in accordance with any of the embodiments disclosed herein. FIG. 1 depicts side cross-sections of the various elements through the phases.

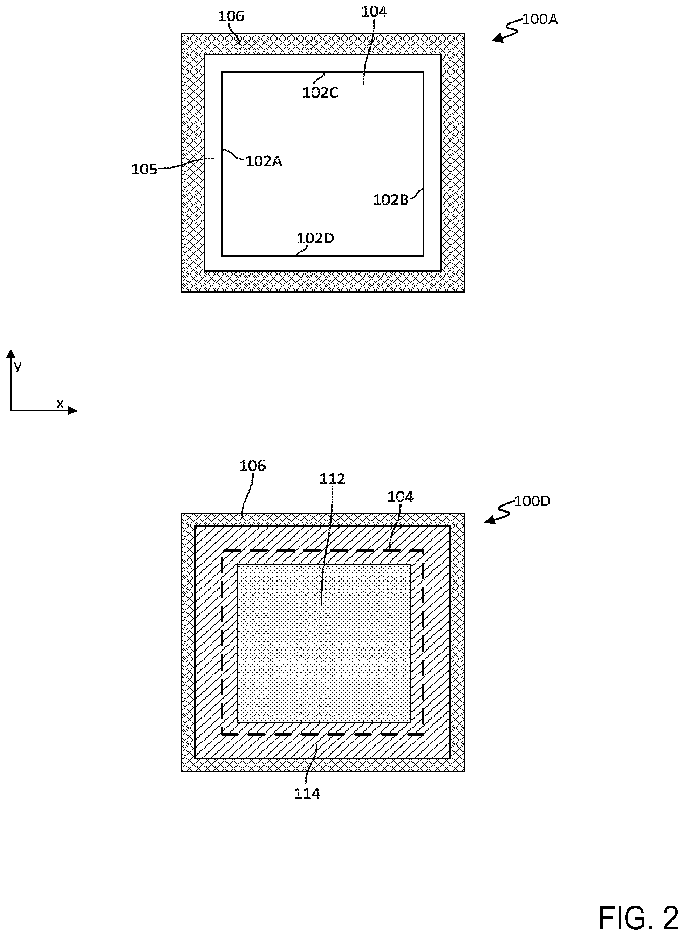

In phase 100A, a glass panel 104 is shown surrounded by a frame 106 proximate the side surfaces 102A and 102B of the glass panel. The frame may be held in position relative to the glass panel 104 by any suitable structure. For example, the frame and the panel could be positioned on a carrier wafer or a tool and/or may be coupled together via an adhesive tape (not shown). As shown in phase 100A of FIG. 2 (which represents a top down view of the panel assembly, where "panel assembly" may be used herein to refer to a glass panel (or multiple smaller glass structures, such as glass quarter panels or glass units) and any attached structures, such as frames, buildup layers, reinforcement materials, etc.), the side surfaces 102 (102A-102D) of the glass panel 104 may be surrounded by the frame 106, with a gap 105 between the panel and the frame.

The glass panel 104 may be secured within the frame 106. This allows the frame to protect the glass panel 104 during various processing steps. For example, one or more tools used during processing of the glass panel 104 may contact the frame 106 instead of the glass panel 104, thus preventing glass breakage that may otherwise occur from contact between the tools and the glass panel or from pressure exerted by such tools. The frame 106 may also impart extra strength to the glass panel 104 to withstand mechanical and other physical agitation caused by various tools handling the glass panel 104 during various process steps.

In some embodiments, the frame 106 may be an organic frame (e.g., the frame may comprise an organic material). For example, the frame 106 may comprise copper clad laminate (CCL). Thus, the frame may include an insulation layer (comprising, e.g., one or more of resin, glass fabric, or a filler material) and one or more metallic layers (e.g., comprising copper). The insulation layer may be sandwiched between two metallic layers.

At phase 100B, a buildup layer 108 is placed on one side (e.g., the depicted top side) of the glass panel 104 and the frame 106. The buildup layer 108 is placed over the entire top surface of the glass panel 104 and over at least a portion of the top surface of the frame 106 (in the depicted embodiment, the buildup layer is placed over a portion of the top surface of the frame 106). Thus, the buildup layer 108 may be placed over the gap 105 between the frame 106 and the glass panel 104.

The buildup layer 108 may be formed in any suitable manner. In one example, the buildup layer is placed by placing a film comprising the buildup layer material (e.g., an Ajinomoto Buildup Film (ABF)) onto the glass panel and the frame.

A reinforcement material 110 is also placed over the buildup layer 108 over the outer perimeter of the glass panel and the inner perimeter of the frame 106. The reinforcement material 110 is placed over at least a portion of the gap 105. In the embodiment depicted, the reinforcement material 110 spans across the entire footprint of the gap 105 (though at a different z-position as it is over the gap). The reinforcement material 110 also spans over a portion of the frame 106 and a portion of the glass panel 104.

At phase 100C, the panel assembly may be turned over and a buildup layer 112 is placed over the opposite surface (previously the bottom surface, but now the top side) of the glass panel 104 and the frame 106. The buildup layer 112 is placed over the entire present top surface of the glass panel 104 and over at least a portion of the present top surface of the frame 106 (in the depicted embodiment, the buildup layer is placed over a portion of the surface of the frame 106). Thus, the buildup layer 112 may also be formed over the gap 105 between the frame 106 and the glass panel 104. In various embodiments, the buildup layer 112 may have the same composition as the buildup layer 108 or may have a different composition.

A reinforcement material 114 is also formed over the buildup layer 112 over the outer perimeter of the glass panel 104 and the inner perimeter of the frame 106. The reinforcement material 114 is formed over at least a portion of the gap 105. In the embodiment depicted, the reinforcement material 114 is placed across the entire footprint of the gap 105. The reinforcement material 114 also spans over a portion of the frame 106 and the glass panel 104. In various embodiments, the reinforcement material 114 may have the same composition as the reinforcement material 110 or may have a different composition.

In various embodiments, the buildup layers and the reinforcement materials may be films. At phase 100D, a lamination process is applied to a side (e.g., top or bottom) of the panel assembly. For example, heat and/or pressure is applied to the buildup layer 108 and the reinforcement material 110. In various embodiments, the lamination may be performed in a vacuum chamber. Within the chamber, heat may be applied to melt the material to be laminated and then the material may be pressed onto the panel (and/or onto another layer). Lamination may also involve a curing step in which cross-linking (hardening) of the material occurs.

In some embodiments, the lamination process may cause the material of the buildup layer 112 to become molten and to flow into the gap 105. The material may completely or partially fill the gap 105. The panel assembly may then be rotated and a lamination process is applied to the other side of the panel assembly. In some embodiments, if the first lamination process did not result in the material of the buildup layer 108 completely filling the gap 105, the second lamination process may cause the material of the buildup layer 108 to become molten and to flow into the gap 105 and to fill the remainder (or at least a portion thereof) of the gap 105.

In some embodiments, the reinforcement material 110 is not flowable (e.g., does not melt during the lamination process), and thus does not enter the gap 105, but rather acts as a stitch between the frame and the glass panel.

Phase 100D of FIG. 2 represents a top down view of the panel assembly. Although the glass panel 104 is not visible, its perimeter is shown in dotted lines. The buildup layer 112 is shown over the glass panel. The frame 106 surrounds the glass panel 104. The reinforcement material 114 is above a portion of the frame 106 and the buildup layer 112. The view may be similar if the assembly is flipped (with buildup layer 108 and reinforcement material 110 visible in place of buildup layer 112 and reinforcement material 114).

The addition of the reinforcement materials 110 and 114 may increase the stiffness and mechanical strength of the panel assembly and provide improved protection of the glass panel 104. In some instances, the reinforcement materials may increase the strength of the panel assembly relative to other materials that may be used to strengthen the interface between the frame and the glass panel, such as glass cloth prepreg (GCP) or resin coated copper (RCC). In some embodiments, the reinforcement materials may have improved mechanical and thermal properties over such alternative materials. For example, in various embodiments, a reinforcement material may have a CTE less than 50 ppm/k, thermal stability above 350 C, and/or a modulus less than 30 Gpa.

In some examples, a reinforcement material 110, 114 may comprise a fluorocarbon polymer (e.g., a polymer comprising fluorine and carbon). For example, a reinforcement material may comprise polytetrafluoroethylene (PTFE), polyvinylidene fluoride or polyvinylidene difluoride (PVDF), or polyvinyl fluoride (PVF).

Although the reinforcement materials are shown as being placed on a respective buildup layer, in other embodiments, a polymer material may be sandwiched in between two buildup layers or on top of a plurality of buildup layers.

In various embodiments, further processing may then be performed on the panel assembly. For example, additional buildup layers and/or other package components may be formed over the glass panel 104, frame 106, and/or reinforcement materials 110, 114 on both the top and bottom sides. The glass panel assembly may then be singulated into one or more units to form package substrates.

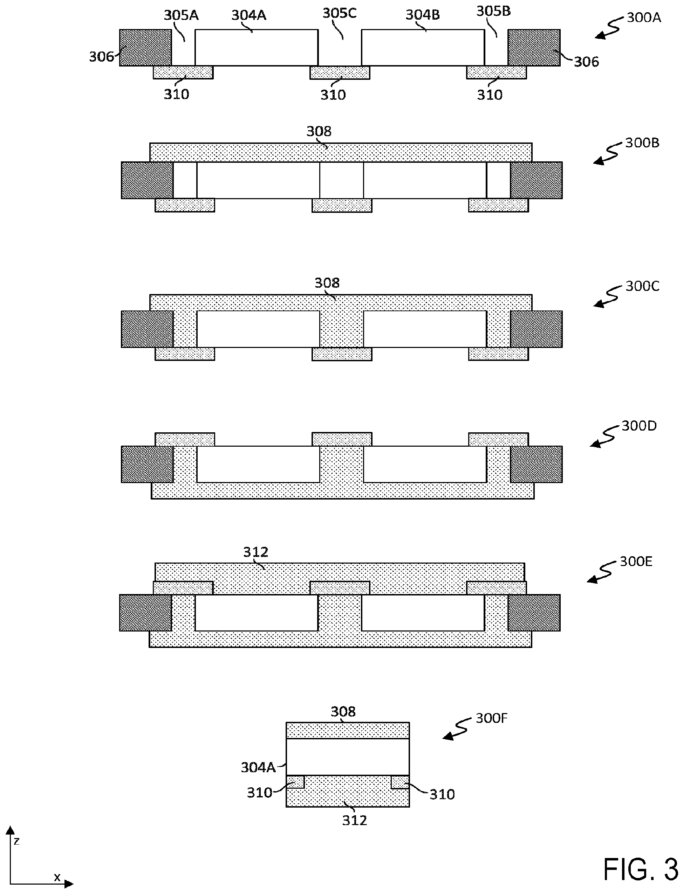

FIG. 3 illustrates various phases 300A-300F of manufacture of package substrates comprising glass cores using a different improved reinforcement material 310, in accordance with any of the embodiments disclosed herein. FIG. 3 depicts side cross-sections of the various elements through the phases.

In phase 300A, two glass quarter panels 304A, 304B are positioned inside of a frame 306. A reinforcement material 310 is placed over the gap 305A between the frame 306 and quarter panel 304A, over the gap 305C between quarter panels 304A and 304B, and over the gap 305B between frame 306 and quarter panel 304B. The panel assembly may then be flipped over such that the reinforcement material 310 is now at the bottom of the panel assembly.

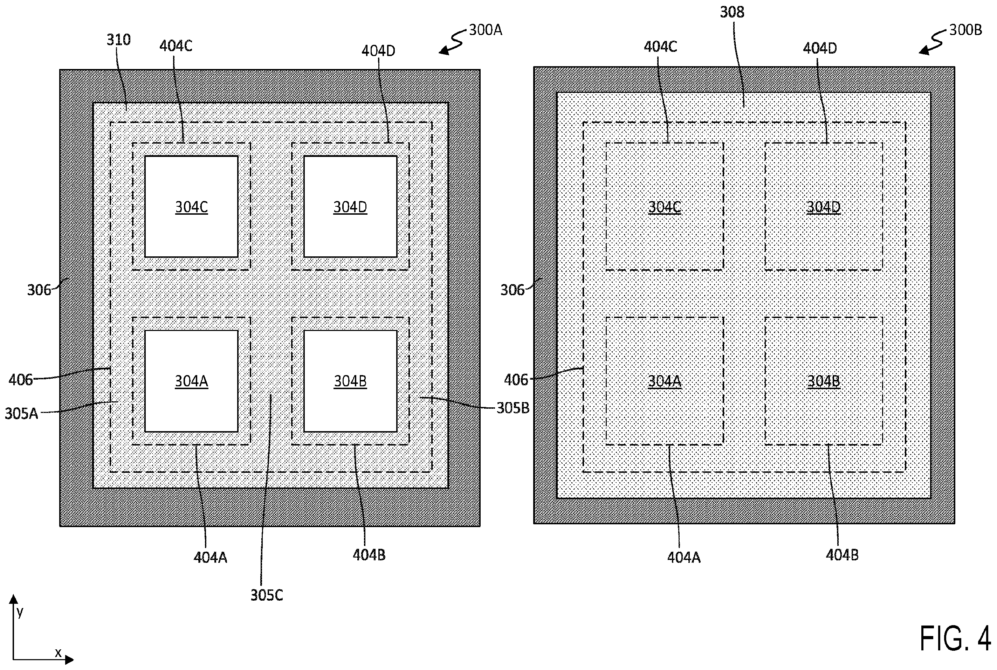

FIG. 4 illustrates the panel assembly at phase 300A from a top down view (from a point of view where the reinforcement material 310 is on the top of the assembly). In this depiction, four quarter panels 304A-D are placed inside of frame 306. The inner perimeter 406 of the frame 306 is depicted in dotted lines. Similarly, the outer perimeters 404A-404D of the quarter panels 304A-D are shown in dotted lines. The reinforcement material 310 is placed over the gaps between quarter panels 304 and the gaps between quarter panels and the frame 306. In various embodiments, the reinforcement material 310 may include one or more strips (e.g., having a rectangular or other shaped cross section in the x-y plane).

Returning to FIG. 3, in some embodiments, the reinforcement material 310 may include strips of tape used to hold the various elements of the assembly together prior to lamination of the first buildup layer. For example, the reinforcement material 310 may comprise a polyimide (PI) tape, such as Kapton tape. The tape may be placed on top of the frame 306 and the quarter panels 304A-D and then the assembly may be turned over for the next process step. In various embodiments, application of the tape may alleviate the need to secure the quarter panels 304A-D and frame 306 together using a jig or other tool prior to formation of the buildup layer 308.

In phase 300B, a buildup layer 308 is placed over at least a portion of the frame 306 and over the entirety of the quarter panels 304A-D. For example, as depicted in phase 300B of FIG. 4, the buildup layer 308 spans the area over the quarter panels 304A-D and is also past the inner perimeter of the frame 306 all the way around the frame 306.

Returning to FIG. 3, in phase 300C, a lamination or molding process is performed and the material of the buildup layer 308 flows into the gaps (e.g., 305A and 305CC) between the frame and the quarter panels and into the gaps (e.g., 305C) between respective quarter panels. Thus, the buildup layer 308 at the lower portions of the gaps may contact the upper surface of the reinforcement material 310.

In phase 300D, the panel assembly is turned over. In phase 300E, buildup layer 312 is formed over the reinforcement material 310. The buildup layer 312 may also be formed over the glass quarter panels 304A-D. In some instances, the buildup layer 312 is formed over a portion of the frame 306 as well (e.g., with the reinforcement material 310 in between the buildup layer 312 and the frame 306). In various examples, the buildup layer 312 may be formed via a lamination or molding process.

Although the embodiment shown includes the reinforcement material 310 on one side of the frame and glass (e.g., the top side in phase 300E), in other embodiments, the reinforcement material 310 (or a different reinforcement material) may also be formed on the other side of the frame and glass (with or without a buildup layer in between the reinforcement material and the glass and/or frame).

In phase 300F, the quarter panels are each singulated. The resulting structure includes a quarter panel (e.g., 304A), a first buildup layer 308 above the quarter panel, and a second buildup layer 312 below the quarter panel. The structure also includes reinforcement material 310 in between the quarter panel and portions of the second buildup layer 312. In this embodiment, the reinforcement material may be present on the bottom surface of the quarter panel 304A proximate the entire outer perimeter of the quarter panel.

In various embodiments, further processing may then be performed on the singulated quarter panel. For example, additional buildup layers and/or other package components may be formed over the glass quarter panel 304A, reinforcement material 310, or buildup layers 308 and 312 on both the top and bottom sides. The singulated quarter panel could also be further singulated (e.g., into one or more units to form package substrates).

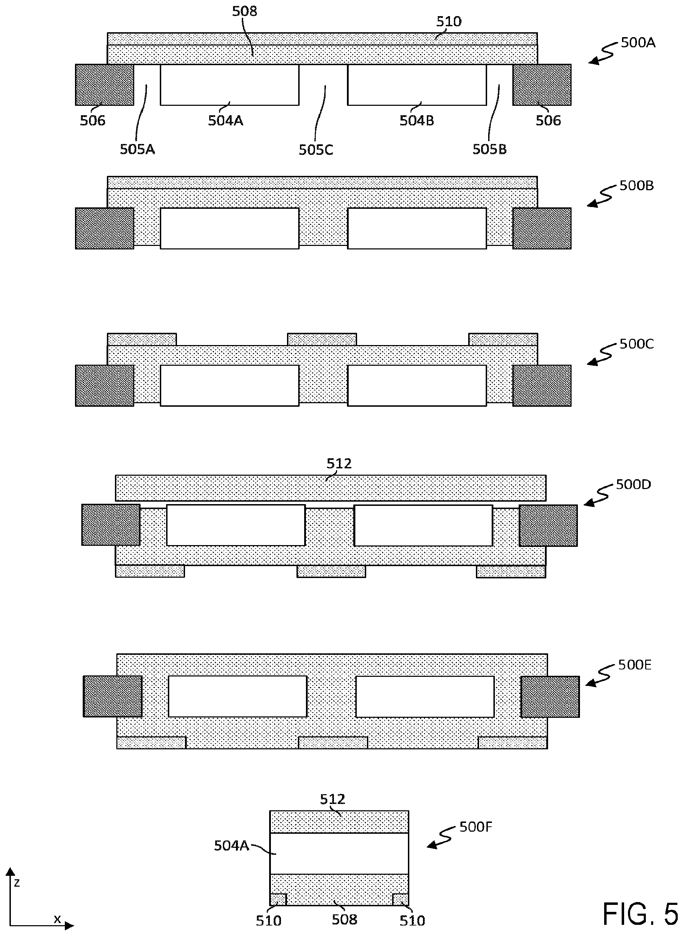

FIG. 5 illustrates various phases 500A-500F of manufacture of package substrates comprising glass cores using another reinforcement material, in accordance with any of the embodiments disclosed herein. FIG. 5 depicts side cross-sections of the various elements through the phases.

In phase 500A, two glass quarter panels 504A, 504B are positioned inside of a frame 506. A buildup layer 508 is placed over the quarter panels 504A, 504B and over a portion of the frame 506. A reinforcement material 510 is placed over the buildup layer 508. In a particular embodiment, the reinforcement material 510 is a film layer comprising polyethylene terephthalate (PET).

At phase 500B, the buildup layer 508 and reinforcement material 510 are laminated or molded and the material of the buildup layer flows into the gaps (e.g., 505A-C).

At phase 500C, portions of the reinforcement material 510 are removed (e.g., etched away) to allow for seamless build up (e.g., additional buildup layers) in the active areas of the quarter panels 504 (e.g., a footprint within which interconnects are to be formed in the buildup layers), while the portions that remain may provide reinforcement between the frame 506 and the quarter panels 504 and/or between pairs of quarter panels. For example, the portions of the reinforcement material 510 that remain after the removal may have similar geographies to the reinforcement material 310 shown in phase 300A of FIG. 4. Thus, the reinforcement material 510 may be placed within the footprint of the gaps 505 (e.g., above the gaps).

At phase 500D, an additional buildup layer 512 is formed on the other side of the quarter panels 504 and frame 506. This additional buildup layer 512 is laminated to form the structure shown in phase 500E. Singulation of the quarter panels is then performed in phase 500F.

Although the embodiment shown includes the reinforcement material 510 on one side of the frame and glass (e.g., the bottom side in phase 500E), in other embodiments, the reinforcement material 510 (or a different reinforcement material) may also be formed on the other side of the frame and glass (with or without a buildup layer in between the reinforcement material and the glass and/or frame).

In phase 500F, the quarter panels are each singulated. The resulting structure includes a quarter panel (e.g., 504A), a first buildup layer 508 below the quarter panel, and a second buildup layer 512 above the quarter panel. The structure also includes reinforcement material 510 in between the quarter panel and portions of the first buildup layer 508. In this embodiment, the reinforcement material may be present on the bottom surface of the quarter panel 504A proximate the entire outer perimeter of the quarter panel.

In various embodiments, further processing may then be performed on the singulated quarter panel. For example, additional buildup layers and/or other package components may be formed over the glass quarter panel 504A, reinforcement material 510, or buildup layers 508 and 512 on both the top and bottom sides. The singulated quarter panel could also be further singulated (e.g., into one or more units to form package substrates).

In various embodiments, the reinforcement material 310 and/or 510 may be any suitable soft and/or flexible plastic or other polymer. For example, the reinforcement material 310 and/or 510 may comprise PI or PET as described above. In other examples, the reinforcement material 310 and/or 510 may comprise polyethylene, polypropylene, PTFE, Ethylene Tetrafluoroethylene (ETFE), or other polymer. In some embodiments, the reinforcement material may have a modulus of between .1 and 10 GPa, a strength of between 5 and 100 MPa, and a toughness of between .1 and 100 MJ/m³. In other embodiments, the reinforcement materials may include any suitable mechanical properties.

A soft plastic or other polymer may provide a tougher and more flexible option to provide improved reinforcement for the fragile gap between the glass panel(s) and the frame when reconstituting substrates. Such materials may be readily available and/or cheaper than other options previously considered. They may also have greater elongation and/or flexibility which can help reinforce the gap area and improve product yield.

While the gap between the frame and the glass panel may be filled with a buildup layer material, in some instances, voids may remain between the frame and glass panel which may result in separation between the frame and the glass panel during subsequent process steps, thus exposing the glass panel to increased risk of cracking. In various embodiments, a combination of lamination and liquid coating may be used to fill the gap between the frame and the glass panel to reduce void formation therein in a cost effective manner.

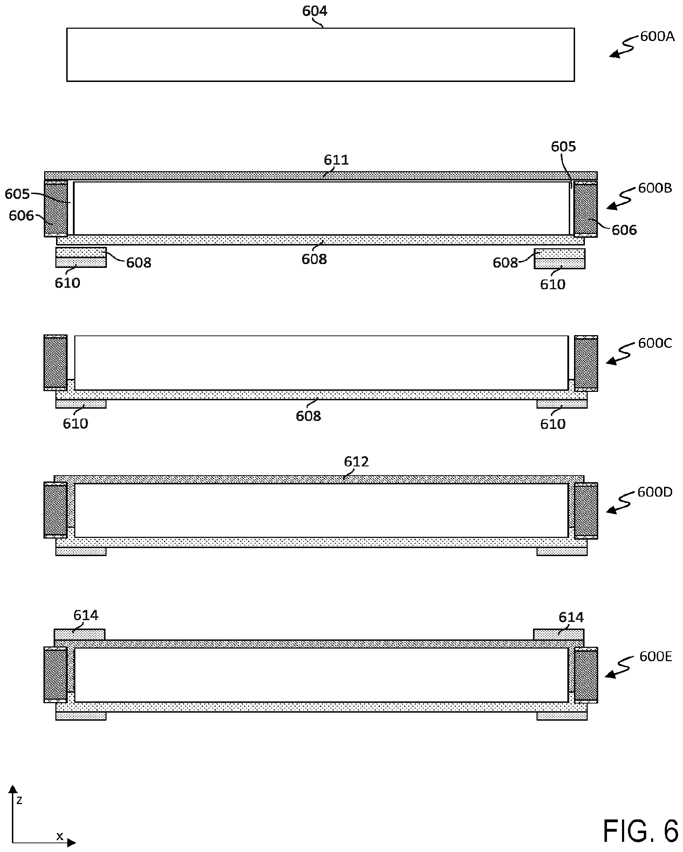

FIG. 6 illustrates various phases 600-604 of manufacture of package substrates comprising glass cores using a liquid polymer to fill gaps, in accordance with any of the embodiments disclosed herein. FIG. 6 depicts side cross-sections of the various elements through the phases.

In phase 600A, a glass panel 604 is positioned. In some instances, a glass bevel etch process may be performed during this phase to create a bevel on the edges of the glass panel that may facilitate locking of the panel into place.

In phase 600B, a frame 606 is positioned around the glass panel 604. A carrier or a protective film 611 is on one side (e.g., the top side in the depiction) of the glass panel 604 and the frame 606. The carrier or protective film 611 may protect the top surface from damage during a lamination process. For example, the carrier or protective film 611 may be placed on the glass panel before the pressing operation of the lamination that occurs in phase 602.

A buildup layer 608 is placed on the other side (e.g., the bottom side in this depiction) of the glass panel. In some embodiments, additional buildup layer material may be placed in the area that spans the gap 605 between the glass panel 604 and the frame 606 (e.g., to compensate for buildup layer material that is to flow into the gap 605 during the lamination process).

A reinforcement material 610 is also formed on the buildup layer 608 (e.g., over the gap 605). The reinforcement material 610 may comprise any suitable material to strengthen the interface between the glass panel 604 and the frame 606 and/or to provide a suitable contact point for tooling. For example, the reinforcement material 610 may comprise GCP, RCC, any of the materials described above for reinforcement materials 110, 310, or 510, or other suitable material.

In phase 600C, a lamination process is applied to the depicted bottom side of the panel assembly. For example, heat and/or pressure is applied to the buildup layer 608 and the reinforcement material 610 and the buildup layer 608 and reinforcement material 610 may be pressed. In some embodiments, this may cause the material of the buildup layer 608 to become molten and to flow into the gap 605. The material may partially fill the gap 105. In various embodiments, only a portion of the gap 105 is filled by the material of the buildup layer 608, where the portion of the gap 105 that is filled is dependent on the thickness of the buildup layer 608. In various embodiments, between 5% and 95% of the height of the gap may be filled by the material of the buildup layer 608. In some embodiments, 100% of the height of the gap may be filled by the material of the buildup layer 608.

The lamination process also helps flatten the polymer material 610. Once the lamination process is completed, the protective film or carrier 611 may be removed (e.g., either after the pressing operation or after a curing operation in which the panel assembly is heated to allow the polymer to crosslink).

In phase 600D, the panel assembly may be rotated and a liquid dispensing method may be used to apply a buildup layer 612 to the other side of the glass panel 604 and the frame 606. The buildup layer 612 may comprise any suitable liquid polymer. In some embodiments, the liquid polymer may include a polymer dissolved in an organic solvent or other flowable polymer. For example, the polymer may comprise ABF or a fluorocarbon polymer such as PTFE, PVDF, or PVF. In various examples, the buildup layer 612 may be applied using any suitable liquid dispensing method, such as slit coating or spin coating. In some instances, a polymer may be dissolved in solvent and then dispensed to form buildup layer 612.

The liquid nature of the polymer may allow the polymer to more easily flow into the gap 605 and to more completely fill in the remaining volume of the gap and/or any voids in the material of the buildup layer previously placed in the gap (e.g., resulting in less voids in the gap 605 relative to if the gap was filled entirely with the material of the buildup layer 612). The combination of the liquid polymer with the laminated buildup material in the gap may enhance the strength of the frame to glass panel interface and thus help prevent cracking of the glass during subsequent process steps.

In various embodiments, the buildup layer 612 and the buildup layer 608 have different compositions and an interface between the buildup layer 612 and the buildup layer 608 may be present in the gap (e.g., buildup layer 612 may be in contact with buildup layer 608). For example, the buildup layer 608 may include a larger percentage of fillers (e.g., silica particles) than the buildup layer 612. As just one example, the buildup layer 608 may comprise roughly 65% fillers and the buildup layer 612 may comprise roughly 60% fillers.

In phase 600E, reinforcement material 614 is placed on the buildup layer 612 (e.g., over the gap 605). The reinforcement material 614 may be the same material as reinforcement material 610 or a different material. In various embodiments, the reinforcement material 614 may be pressed onto the panel assembly and cured. The reinforcement material 614 may serve a similar function to that of reinforcement material 610.

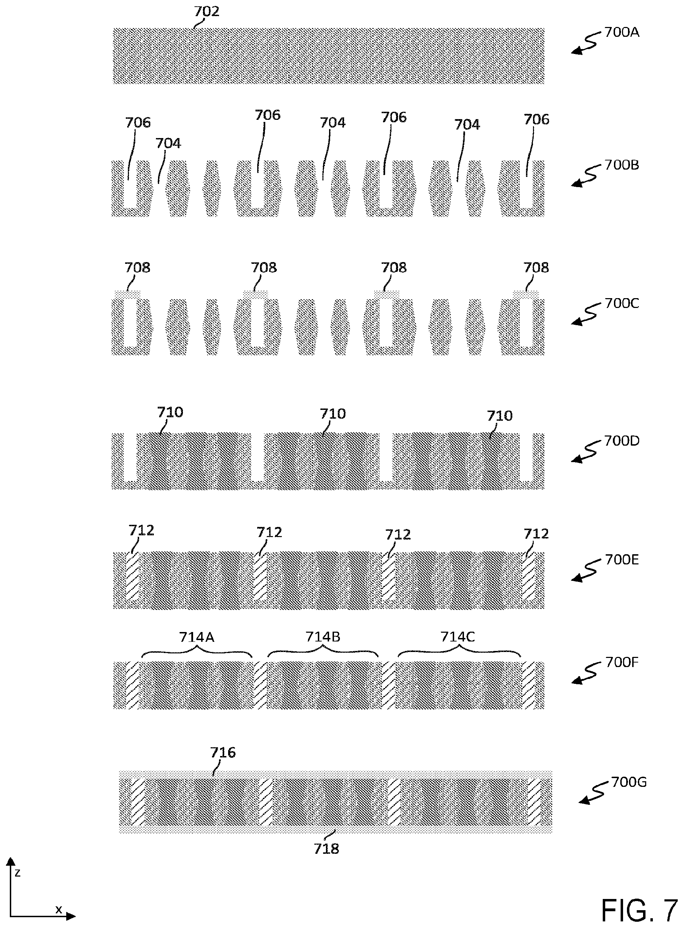

FIG. 7 illustrates various phases 700A-700G of manufacture of package substrates comprising glass cores and an epoxy material, in accordance with any of the embodiments disclosed herein. FIG.7 depicts side cross-sections of the various elements through the phases.

At phase 700A, a glass panel 702 is positioned. At 700B, a plurality of through holes 704 and cavities 706 are formed in the glass panel. The through holes 704 and/or cavities 706 may be formed in any suitable manner, such as through mechanical drilling (using drill bits, blasts, or other methods), thermal drilling (e.g., laser drilling), chemical methods (e.g., etching), or other suitable methods. The through holes 704 are used to create through-glass vias (TGVs), while the cavities are used to form a plurality of unit panels from the glass panel 702.

At phase 700C, a dry film resist (DFR) 708 is placed over the cavities 706 to protect the cavities from the plating process that is used to form the TGVs. The DFR may be formed via any suitable method, such as patterning via photolithography.

At phase 700D, a seed material is formed in the through holes 704 to assist with the formation of the through-glass vias. The dry film resist 708 may block the seed from forming in the cavities 706. The through-glass vias 710 are then formed by forming a conductive material (e.g., a metal such as copper) within the holes 704. This process may be referred to as through hole plating.

At phase 700E, the cavities 706 are filled with an epoxy material 712 (e.g., a graphene doped epoxy material). In various examples, the epoxy material 712 is a low CTE epoxy material. In some embodiments, the CTE of the epoxy material 712 is in the range of 2-12 ppm/K. In some instances, the epoxy material 712 may comprise between .01% and 5% of graphene filler by volume. The epoxy material 712 may have excellent mechanical and thermal properties. For example, the epoxy material 712 may have a modulus of between 1 and 10 GPa, a strength of between 50 and 1000 MPa, and/or a toughness of between 1 and 1000 MJ/m³. In various embodiments, a liquid mold dispensing tool may be used to fill the cavities with the epoxy material 712.

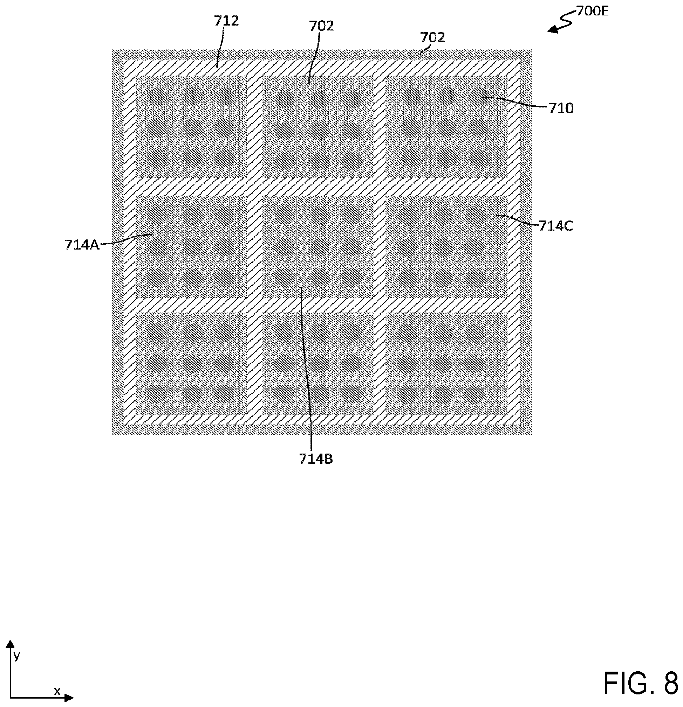

FIG. 8 illustrates a top view of the panel assembly at phase 700E. As illustrated, the various glass unit panels are completely surrounded on all four sides by the epoxy material 712. The through-glass vias 710 are shown in each glass unit panel.

Referring again to FIG. 7, at phase 700F, the bottom portion of the panel assembly (e.g., the portion below the bottoms of the cavities 706) is removed. For example, the bottom portion may be grinded until the epoxy material 712 is exposed on the bottom side.

At phase 700G, a buildup layer 716 is formed on the top of the assembly and a buildup layer 718 is formed on the bottom of the assembly. Additional buildup layers may be formed above the buildup layer 716 and below the buildup layer 718 and/or other processing steps may be performed (e.g., formation of other package components and singulation).

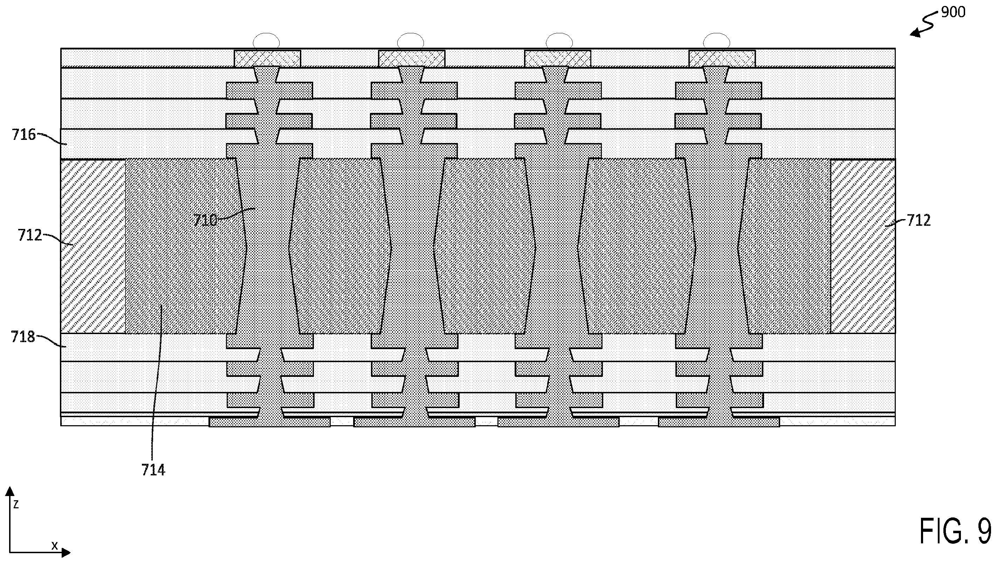

FIG. 9 illustrates a side cross section of a package 900 with a glass unit panel 714 (which may also be referred to as a glass core) after singulation. The package includes the glass unit panel 714 encapsulated by the epoxy material 712. The package also includes the TGVs 710, buildup layer 716, and buildup layer 718, as well as other buildup layers and conductive portions (e.g., interconnect layers and contacts on the top of the package).

Since the glass panel is fully encapsulated (e.g., on all four side surfaces) with an epoxy material (and thus may have flush edges with no exposed glass), the panel has a significantly reduced risk of glass core separation during substrate processing, package assembly, testing, and in-field use. Moreover, the unit level singulation may be performed using a traditional dicing type cutting tool (e.g., a disc cutter w/ resin blades) rather than more expensive and/or complicated specialty tools (e.g., laser based singulation tools).

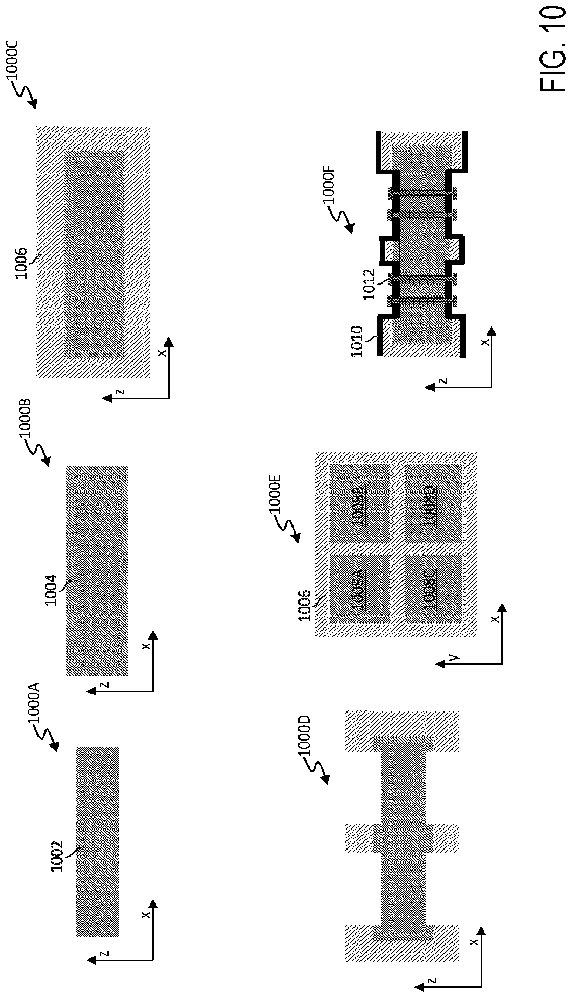

FIG. 10 illustrates various phases 1000A-1000F of manufacture of package substrates comprising glass cores using a photo-imageable dielectric (PID) frame, in accordance with any of the embodiments disclosed herein. Phases 1000A-D and F depict side cross-sections of the various elements through the phases while phase 1000E depicts a top-down view.

At phase 1000A a glass panel 1002 is positioned. At 1000B, an intermediate layer 1004 (e.g., a seed layer or silicon nitride (SiN)) is deposited directly on the glass panel 1002. Any suitable seed layer may be used. In one embodiment, the seed layer comprises titanium and copper (e.g., with titanium deposited on the glass surface first since it adheres better to glass, and then copper deposited on the titanium). In various embodiments, the intermediate layer 1004 may be deposited on all of the surfaces of the glass panel 1002.

At phase 1000C, a photo-imageable dielectric (PID) 1006 is formed over (e.g., laminated or coated onto) the glass panel 1002 over the intermediate layer. In various embodiments, the PID may include a polyimide, an epoxy, a siloxane, an acrylic, or other suitable dielectric. In various embodiments, the PID may have a relatively high modulus, such as over 20 GPa (e.g., between 20 - 70GPa) or even over 80 GPa in some embodiments. Such embodiments may provide superior protection to the glass encased therein.

In one embodiment the PID is a dry film that is laid down on the glass panel (or on the intermediate layer if present), cut to the desired length, and pressed onto the glass panel 1002 during lamination. In other embodiments, the PID may be liquid and may applied to the glass panel 1002 (or on the intermediate layer if present) in any suitable manner, such as through slit coating or spin coating.

At phase 1000D, portions of the intermediate layer 1004 and the PID 1006 are removed to expose the surface of the glass panel 1002. For example, portions of the PID 1006 may be removed through lithography patterning and portions of the intermediate layer 1004 may be removed by etching. As shown in phase 1000E (which is a top-down view corresponding to phase 1000D), the removal may result in the formation of glass quarter panels 1008A-D. At this stage, these quarter panels are still part of the same glass panel but have top and bottom surfaces that are separated from each other by the intermediate layer 1004 and PID 1006 that remain on the top and bottom surfaces.

At phase 1000F, downstream processing may be performed, such as the formation of a metal interconnect layer 1010 as well as TGVs 1012 (in other embodiments, the TGVs may be formed in phase 1000A, before the application of the intermediate layer 1004 and/or PID 1006). In various embodiments, further downstream processing steps may be performed, such as the formation of buildup layers and other package components as well as singulation. The PID frame may protect the glass throughout the processing as various tools may contact the PID frame rather than the glass.

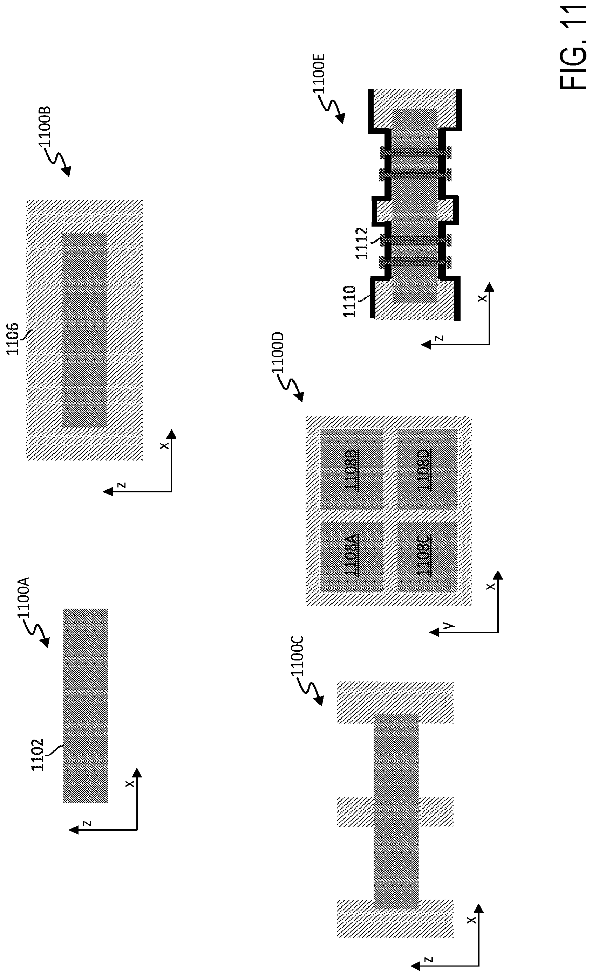

FIG. 11 illustrates various phases 1100A-1100E of manufacture of package substrates comprising glass cores using a PID frame without an intermediate layer, in accordance with any of the embodiments disclosed herein. Phases 1100A-C and E depict side cross-sections of the various elements through the phases while phase 1100D depicts a top-down view. The process shown in FIG. 11 is similar to the process of FIG. 10, but omits an intermediate layer.

At phase 1100A a glass panel 1102 is positioned. At phase 1100B, PID 1106 is formed (e.g., laminated or coated) directly onto the glass panel 1102 without an intervening layer in between. At phase 1100C, portions of the PID 1106 are removed (e.g., through photolithography patterning) to expose the surface of the glass. As shown in phase 1100D (which is a top-down view corresponding to phase 1100C), the removal may result in the formation of glass quarter panels 1108A-D.

At phase 1100F, downstream processing may be performed, such as the formation of a metal interconnect layer 1110 as well as TGVs 1112 (in other embodiments, the TGVs may be formed in phase 1100A, before the application of the PID 1106). In various embodiments, further downstream processing steps may be performed, such as the formation of buildup layers and other package components as well as singulation. The PID frame may protect the glass throughout the processing as various tools may contact the PID frame rather than the glass.

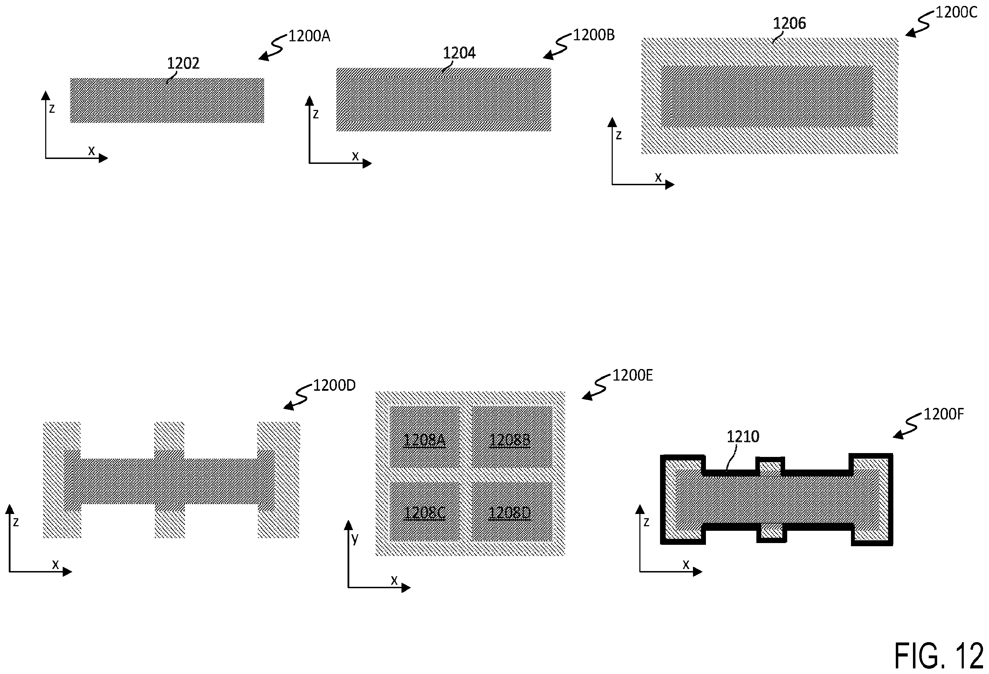

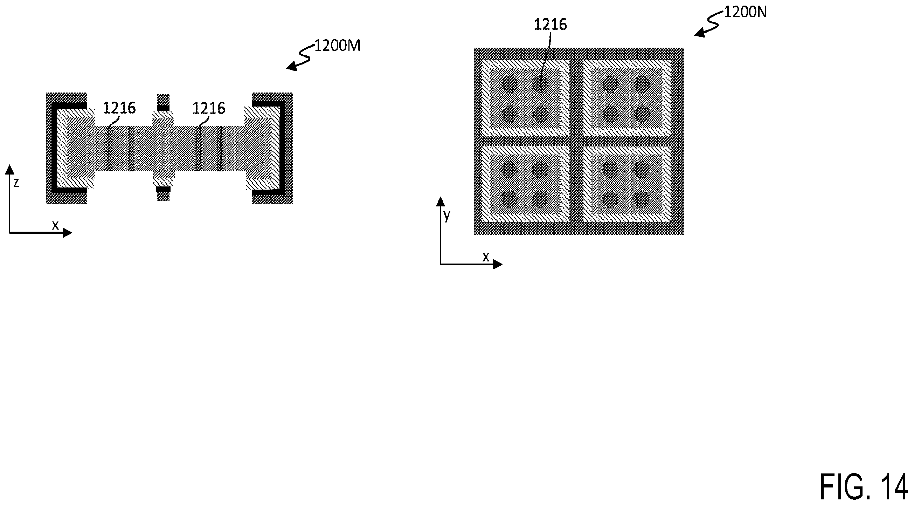

FIGS. 12-14 illustrate various phases 1200A-1200N of manufacture of package substrates comprising glass cores using a PID and metallic frame, in accordance with any of the embodiments disclosed herein. Phases 1200A-D, F-K, and M depict side cross-sections of the various elements through the phases while phase 1200E, L, and N depict a top-down view.

At phase 1200A a glass panel 1202 is positioned. At 1200B, an intermediate layer 1204 (e.g., a seed layer such as that described above or silicon nitride (SiN)) is deposited on the glass panel 1202. In various embodiments, the intermediate layer may be deposited on all of the surfaces of the glass panel 1202.

At phase 1200C, PID 1206 is formed (e.g., laminated or coated) on the glass panel 1202 over the intermediate layer 1204. In other embodiments, if the PID has good adhesion to the glass, the intermediate layer 1204 may be omitted and the PID may be formed directly onto the glass (e.g., as shown in FIG. 11).

At phase 1200D, portions of the intermediate layer 1204 and the PID 1206 are removed (e.g., via etching and photolithography patterning) to expose portions of the top and bottom surface of the glass. As shown in phase 1200E (which is a top-down view corresponding to phase 1200D), the removal may result in the formation of glass quarter panels 1208A-D.

At phase 1200F, another seed layer 1210 is formed (e.g., deposited) on the remaining intermediate layer 1204 and PID 1206 as well as the glass panel 1202. The seed layer 1210 may be the same as the seed layer of intermediate layer 1204 or may be different. In various embodiments, the seed layer 1210 includes copper or copper and titanium.

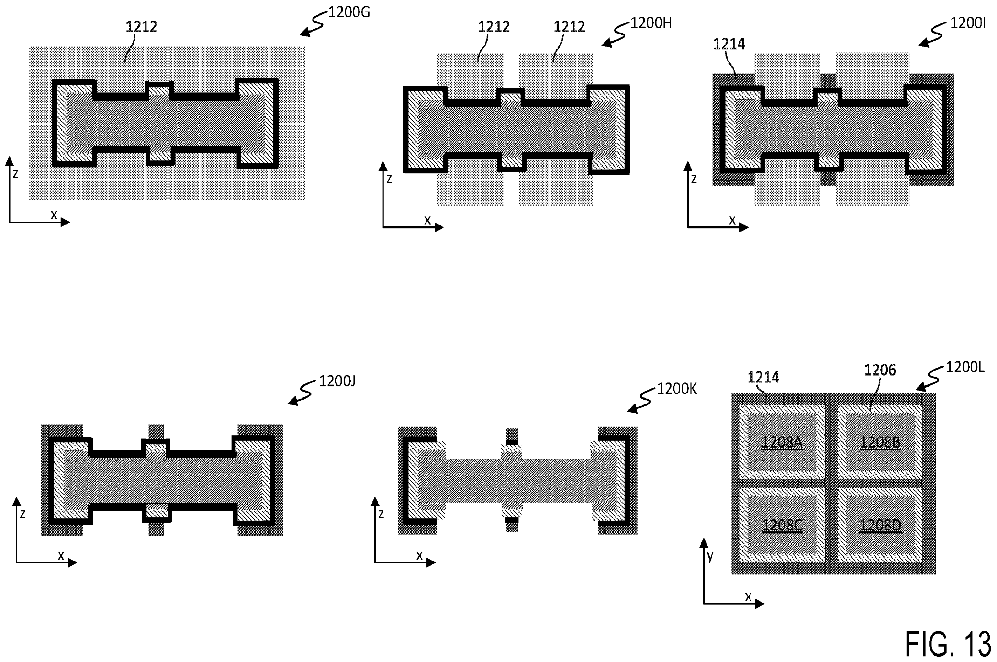

At phase 1200G of FIG. 13, a dry film resist (DFR) 1212 is formed (e.g., laminated) on the assembly. At phase 1200H, portions of the DFR are removed (e.g., via lithography patterning). The portions of the DFR 1212 that remain may protect portions of the glass quarter panels (e.g., the active areas of the glass quarter panels) from the metallic plating that occurs in phase 1200I.

At phase 1200I, a metallic layer 1214 is formed on the exposed seed layer 1210 around the entire sides and on portions of the top and bottom of the glass panel 1202. The metallic layer 1214 is also formed on the exposed seed layer 1210 on borders on the top and bottom surfaces between the glass quarter panels 1208. In various embodiments, the metallic layer 1214 comprises one or more of copper, silver, gold, nickel, tin, aluminum, iron, cobalt, or other conductive metal or alloy metal (e.g., Invar).

At phase 1200J, the remaining DFR is removed (e.g., by stripping it). At phase 1200K, the newly exposed portions of the seed layer 1210 are removed (e.g., by etching).

As shown in phase 1200L (which is a top-down view corresponding to phase 1200K), the quarter panels 1208 now have both PID 1206 and the metallic layer 1214 on the perimeters of the top surface of quarter panels 1208A-D (similarly, the PID 1206 and metallic layer may border the quarter panels on the bottom surface). As shown in phase 1200K, the PID 1206 and the metallic layer 1214 also surround the side surfaces of the glass panel 1202. At phase 1200M, TGVs 1216 are formed in the glass quarter panels. Phase 1200N depicts the resulting top-down view. In other embodiments, the TGVs may be formed in phase 1200A, before the application of the intermediate layer 1004 and/or PID 1006). Additional downstream processing may then be performed, such as formation of buildup layers, interconnect layers, contacts, or other suitable elements, as well as singulation.

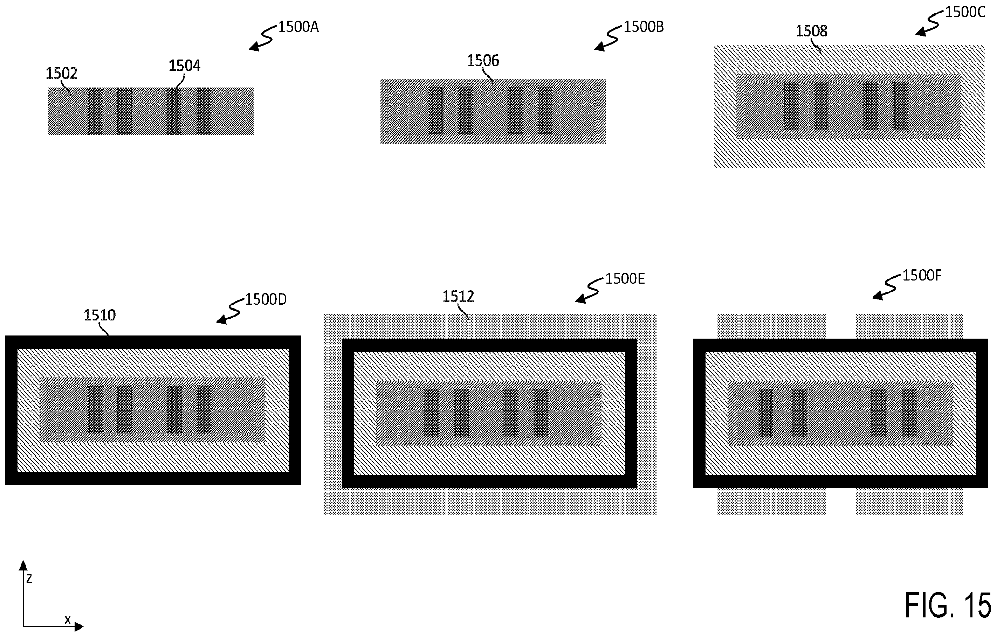

FIGS. 15-16 illustrate various phases 1500A-1500K of manufacture of package substrates comprising glass cores using a non-patterned PID and metallic frame, in accordance with any of the embodiments disclosed herein. Phases 1500A-J depict side cross-sections of the various elements through the phases while phase 1500K depicts a top-down view. In this embodiment, the PID is not patterned and remains on the glass as a buffer layer.

At phase 1500A a glass panel 1502 is positioned and TGVs 1504 are formed in the glass panel. At 1500B, an intermediate layer 1506 (e.g., a seed layer such as that described above or silicon nitride (SiN)) is deposited on the glass panel 1502. In various embodiments, the intermediate layer may be deposited on all of the surfaces of the glass panel 1502.

At phase 1500C, PID 1508 is formed (e.g., laminated or coated) over the glass panel 1502 over the intermediate layer 1506. In other embodiments, if the PID has good adhesion to the glass, the intermediate layer 1506 may be omitted and the PID may be formed directly onto the glass panel.

At phase 1500D, a seed layer 1510 (such as any of those describe above) is deposited on the PID 1508. At phase 1500E, DFR 1512 is formed (e.g., laminated) over the seed layer 1510. At phase 1500F, portions of the DFR are removed (e.g., via lithography patterning). The portions of the DFR 1512 that remain may protect portions of quarter panels of the glass (e.g., the active areas of the glass quarter panels) from the metallic plating that occurs in phase 1500G.

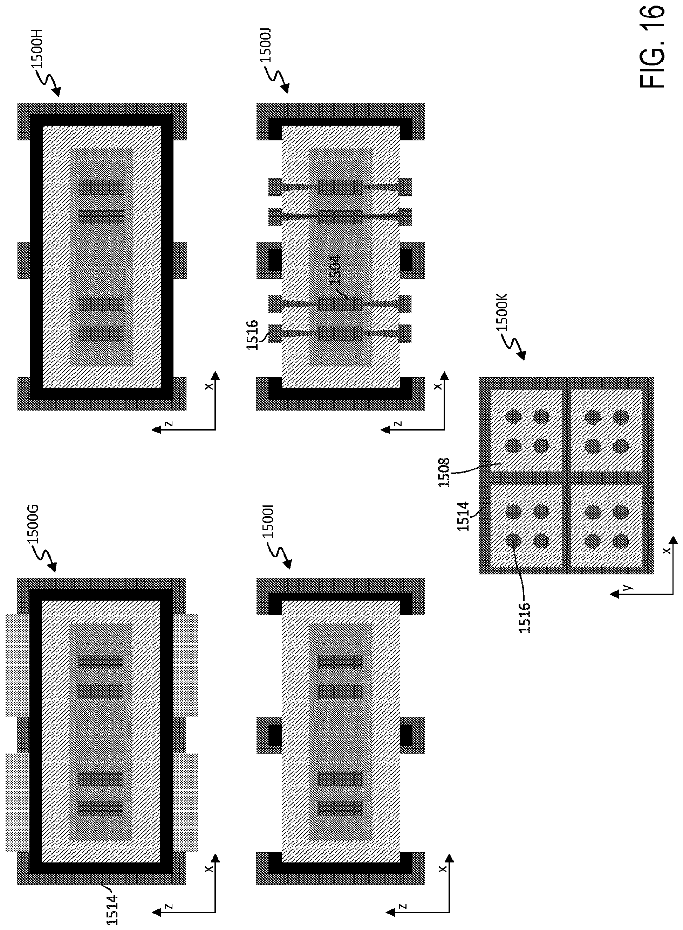

At phase 1500G of FIG. 16, a metallic layer 1514 is formed on the exposed seed layer 1510 on the side surfaces of the glass panel 1502. The metallic layer 1514 is also formed on the exposed seed layer 1510 on the top and bottom surfaces of the glass panel 1502 (e.g., which may define the borders between quarter panels). In various embodiments, the metallic layer 1514 comprises one or more of copper, silver, gold, nickel, tin, aluminum, iron, cobalt, or other conductive metal or alloy metal (e.g., Invar).

At phase 1500H, the remaining DFR is removed (e.g., by stripping it). At phase 1500I, the exposed portions of the seed layer 1510 are removed (e.g., through etching). At phase 1500J, contacts 1516 and connections to the TGVs 1504 are formed on and through the PID 1508.

As shown in phase 1500K (which is a top-down view corresponding to phase 1500J), the metallic layer 1514 above the top surface and below the bottom surface of the glass panel divides the glass panel into quarter panels 1518A-D. The PID 1508 and the metallic layer 1514 also encase the side surfaces of the glass panel 1502 and the PID is over the top and bottom surfaces of the quarter panels.

Additional downstream processing may then be performed, such as formation of buildup layers, interconnect layers, contacts, or other suitable elements, as well as singulation.

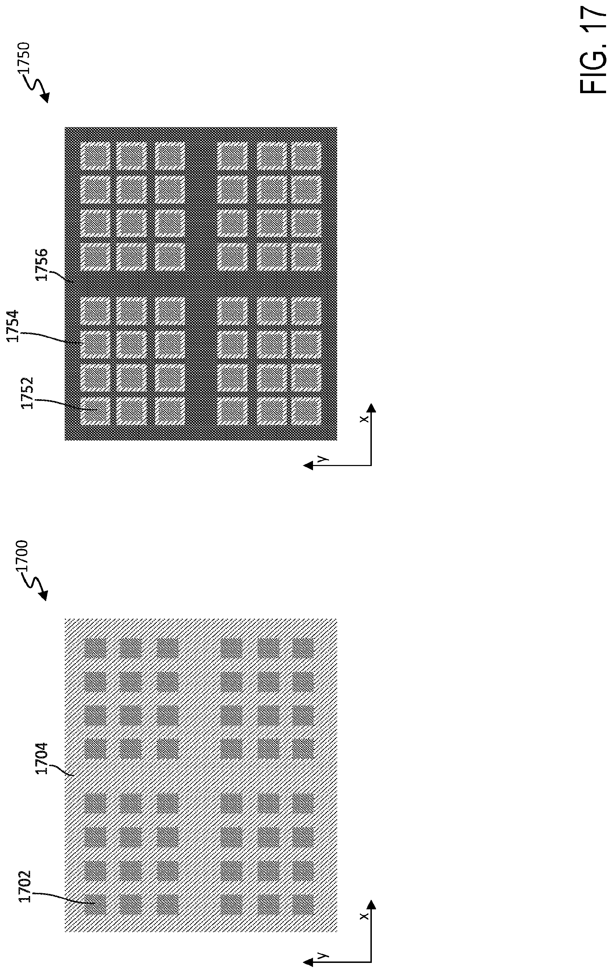

FIG. 17 illustrates top-level views of a unit level PID frame 1700 for a glass panel and a unit level PID and metal frame 1750 for a glass panel, in accordance with any of the embodiments disclosed herein. The frames may be formed in a manner similar to that described above, however here the patterning is different so as to form unit panels which are smaller than the quarter panels shown above.

The frame 1700 includes PID 1704 formed around a glass panel that may be divided into units 1702, where a unit includes a portion of the glass panel that may be included as the glass core in a single package. Thus, the glass panel assembly may be singulated into units at some stage in the package manufacturing process. Frame 1700 includes PID 1704 around the side surfaces of the entire panel as well as PID around the footprint of each unit above the top surface and below the bottom surface of the respective unit (similar to that described above with respect to FIG. 12 where the PID is formed around the footprints of the quarter panels).

The unit level PID and metal frame 1750 includes PID 1754 and a metal 1756 around the side surfaces of the entire panel as well as PID and metal around the footprint of each unit 1752 above the top surface and below the bottom surface of the respective unit (similar to that described above with respect to FIG. 13 where the PID and metal is formed around the footprints of the quarter panels).

Although various embodiments herein have been described with respect to glass panels, glass quarter panels, or glass unit panels, the embodiments may be adapted to other configurations. For example, embodiments using glass panels may be adapted to glass quarter panels or glass unit panels, embodiments using glass quarter panels may be adapted to glass panels or glass unit panels, or embodiments using glass unit panels may be adapted to glass panels or glass quarter panels. Similarly, the embodiments could be adapted to other size panels (e.g., half panels within a frame, six individual panels within a frame, eight individual panels within a frame, etc.).

As an example, reinforcement materials 110 and 114 could also be placed above or below the footprints of gaps between quarter panels or unit panels (in a manner similar to reinforcement materials 310 and 510. As another example, buildup layer 612 could be placed in between gaps between individual panels (e.g., quarter panels or unit panels). As another example, PID 1006 or 1206, and/or metallic layer 1214 could be omitted in between individual quarter panels (e.g., such that they are used to frame the outer edges of a single panel). Any other suitable arrangements are contemplated herein.

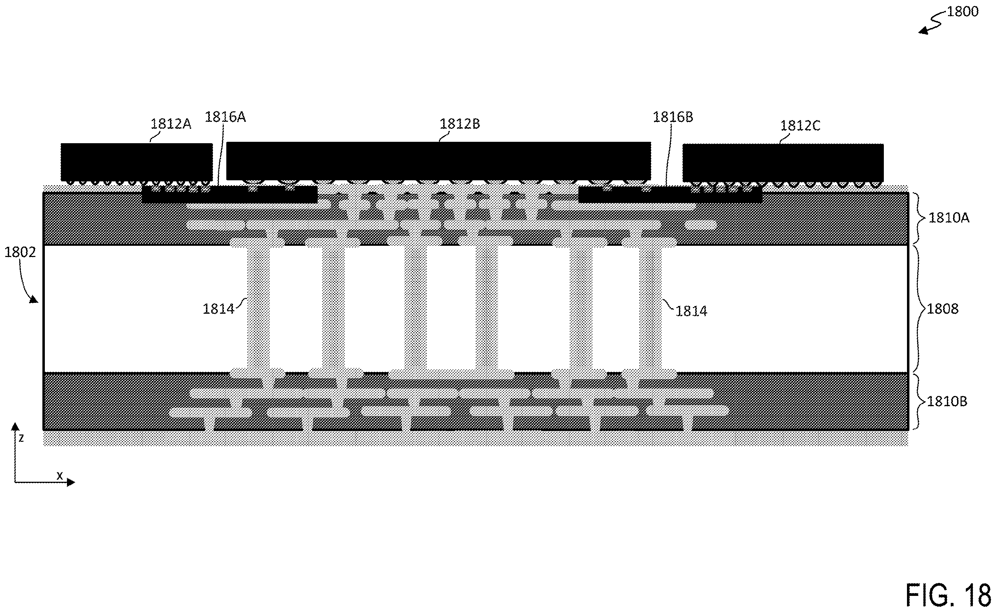

FIG. 18 illustrates a package 1800 comprising a glass core 1808 (which may comprise at least a portion of any of the glass panels described above). The package 1800 includes a package substrate 1802 which may be formed using any of the steps described above with respect to the various panel assemblies (and/or other suitable process steps). For example, the package 1800 (or a portion thereof) may be singulated from a panel assembly as described above. Thus, the package 1800 (or a portion thereof) may include a unit panel as described above. In various embodiments, after singulation is performed on a panel assembly, additional processing may be performed to form a package (e.g., 1800).

The package substrate 1802 may comprise a glass core 1808, a first outer portion 1810A above the glass core 1808, and a second outer portion 1810B below the glass core 1808. The first outer portion 1810A and/or the second outer portion 1810B may each comprise one or more buildup layers. Vias 1814 (TGVs) are formed through the glass core 1808.

A first outer portion 1810A and second outer portion 1810B comprising buildup layers are formed respectively on the top and bottom sides of the glass core 1808, with the first outer portion 1810A on the top side of the glass core 1808 and the second outer portion 1810B on the bottom side of the glass core 1808. Any of the buildup layers previously described may have any of the characteristics of other buildup layers described herein (including those described below in connection with FIG. 18).

The buildup layers may comprise alternating conductive layers and insulating layers, where a conductive layer may have any number of different (e.g., electrically isolated) interconnects on the same plane of the package substrate. In some embodiments, a conductive layer may comprise patterned metal (e.g., copper, aluminum, tungsten, gold, etc.) forming signal or power/ground plane layers and may be bordered by one or more dielectric materials to electrically isolate the patterned metal. For example, the buildup layers may include metal traces in metallization layers and pillars between the metallization layers as shown to electrically couple components on the top of the package 1800 with conductive contacts (e.g., pads) at the bottom of the package. For example, the buildup layers may provide connections between IC dies 1812 (e.g., 1812A-C) coupled to the top side of the package and components (e.g., circuits, IC dies, or other electronic devices) coupled to a circuit board (e.g., a motherboard, main board, etc.) through the conductive contacts at the bottom of the package.

The buildup layers may comprise any suitable dielectric materials including one or more of an organic resin (e.g., Ajinomoto Buildup Film), a ceramic, an epoxy film, an epoxy based organic material, inorganic dielectrics (e.g., silicon dioxide, silicon nitride, fluorine-doped silicon dioxide, hydrogen-doped silicon dioxide, etc.), carbon-doped silicon dioxide, photo-imageable dielectric (PID), or suitable filler materials (e.g., silica particle fillers). In some embodiments, a buildup layer comprises an organic resin matrix with different types of fillers (for example, silica fillers of different sizes and/or hollow fillers of different sizes). In some embodiments, the outer portion 1810 (or at least some of the layers of an outer portion) do not have fibers.

A buildup layer may be formed in any suitable manner, such as through placement, lamination, molding (e.g., overmolding), dispensing, deposition, or other suitable method.

One side of the package substrate may interface with one or more IC dies 1812. The dies 1812 may include any suitable logic. For example, a die 1812 may comprise an XPU (such as a central processing unit or other processor), a transceiver, a memory, a network interface controller, or other suitable logic.

The top side of the package substrate may include conductive contacts (e.g., solder pads) that couple to conductive contacts of the IC dies 1812 (e.g., via a solder connection). The package substrate may be coupled to any number of IC dies 1812, e.g., via a flip chip technique, wire bonding, and/or other suitable couplings. Another side of the package substrate (e.g., a bottom side) that is opposite to the first side may interface with a circuit board, other integrated circuit dies, and/or passive component structures. For example, solder balls may be formed on conductive contacts and used to couple the conductive contacts of the package 1800 to corresponding conductive contacts of a circuit board and/or other components. A conductive contact may comprise any suitable conductive material (e.g., copper) arranged in any suitable shape. In some examples, the package 1800 has bumps, leads, or pins attached to the package substrate 1802 (either directly or by wires attaching the bumps, leads, or pins to the package substrate) for attaching the package 1800 to a printed circuit board (or motherboard or base board) or another component.

In the depicted embodiment, embedded bridge dies 1816 (e.g., 1816A and 1816B) are embedded within the first outer portion 1810A. An embedded bridge die 1816 may comprise a die with conductive material (e.g., a plurality of metal layers, not explicitly shown) to provide connections between conductive contacts (e.g., pads) of two or more IC dies 1812. The embedded bridge die 1816 may include any suitable passive and/or active components to interconnect IC dies (e.g., 1812A and 1812B or 1812B and 1812C). In some embodiments, the embedded bridge die may be an Intel^{®} embedded multi-die interconnect bridge with through silicon vias (EMIB-T). In various embodiments, an embedded bridge die 1816 comprises a small silicon die embedded in the package substrate under the edges of the dies the respective bridge die couples together.

The package substrate may also include a plurality of TGVs 1814. The TGVs 1814 may be vias extending between a first side and a second side of the glass core 1808 (e.g., between the bottom face and the top face of the glass core 1808). The vias may include any appropriate conductive material, e.g., a metal such as copper, silver, nickel, gold, aluminum, or other metals or alloys, for example. The TGVs 1814 may be formed using any suitable process, including, for example, a direct laser drilling or laser induced deep etching process. In some embodiments, the TGVs 1814 disclosed herein may have a pitch between 50 microns and 500 microns, e.g., as measured from a center of one TGV 1814 to a center of an adjacent TGV 1814. The TGVs 1814 may have any suitable size and shape. In some embodiments, the TGVs 1814 may have a circular, rectangular, or other shaped cross-section. In some embodiments, at least some of the TGVs 1814 may have an hourglass shape. In some embodiments, at least some of the TGVs 1814 may taper down from one face of the glass core 1808 to another, e.g., from the top face of the glass core 1808 to the bottom face of the glass core 1808. A TGV may provide a conductive path from an interconnect of one conductive layer of the package substrate 1802 to an interconnect of another conductive layer.

In some embodiments, the IC dies 1812 and package substrate 1802 may be encapsulated in a casing material, such as a metal, plastic, glass, or ceramic. The casing may include an integrated heat spreader (IHS).

Where various characteristics are described or illustrated in a particular FIG. for a particular component (e.g., a panel, subpanel, quarter panel, unit panel, core, substrate, buildup layer, frame, etc.), the various embodiments described herein contemplate that any suitable combination of such characteristics may also apply to the same component as described or illustrated in another FIG.

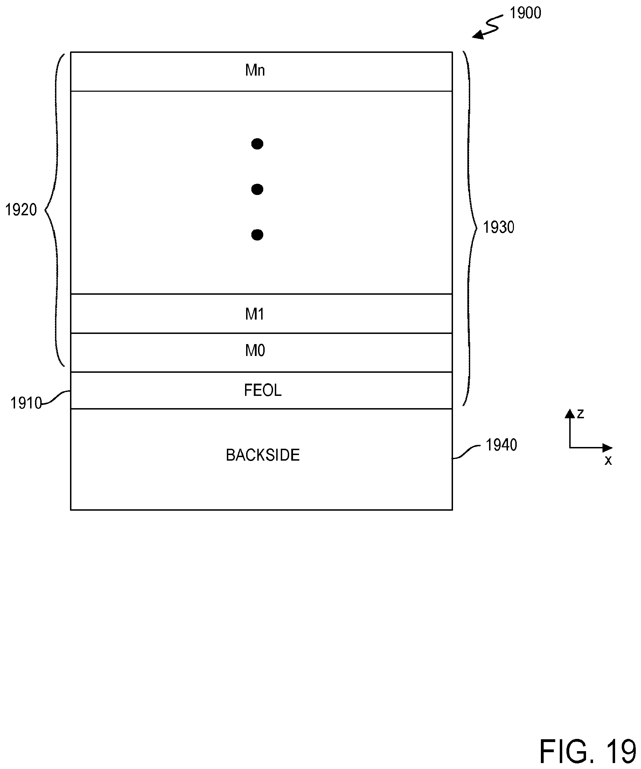

FIG. 19 provides a schematic illustration of a cross-sectional view of an example integrated circuit device (e.g., a chip or die) 1900. The IC device 1900 may include transistors as well as other circuit elements (e.g., resistors, diodes, capacitors, inductors, etc.). The IC device 500 may represent a die that may be attached to a package substrate in various embodiments.

As shown in FIG. 19, the IC device 1900 may include a front side 1930 comprising a front-end-of-line (FEOL) 1910 that includes various logic layers, circuits, and devices to drive and control a logic IC. These circuits and devices may be configured for any number of functions, such as logic or compute transistors, input/output (I/O) transistors, access or switching transistors, and/or radio frequency (RF) transistors, to name a few examples. According to some embodiments, in addition to these devices and circuits, FEOL 1910 may include, for example, one or more other layers or structures associated with the semiconductor devices and circuits. For example, the FEOL can also include a substrate and one or more dielectric layers that surround active and/or conductive portions of the devices and circuits. The FEOL may also include one or more conductive contacts that provide electrical contact to transistor elements such as gate structures, drain regions, or source regions. The FEOL may also include local interconnect (e.g., vias or lines) that connect contacts to interconnect features within a back-end-of-line (BEOL) 1920.

The front side 1930 of the IC device 1900 also includes a BEOL 1920 including various metal interconnect layers (e.g., metal 0 through metal n, where n is any suitable integer). Various metal layers of the BEOL 1920 may be used to interconnect the various inputs and outputs of the FEOL 1910.

Generally speaking, each of the metal layers of the BEOL 1920, e.g., each of the layers M0-Mn shown in FIG. 19, may include a via portion and a trench/interconnect portion. Typically, the trench portion of a metal layer is above the via portion, but, in other embodiments, a trench portion may be provided below a via portion of any given metal layer of the BEOL 1920. The trench portion of a metal layer may be configured for transferring signals and power along metal lines (also sometimes referred to as "trenches") extending in the x-y plane (e.g., in the x or y directions), while the via portion of a metal layer may be configured for transferring signals and power through metal vias extending in the z-direction, e.g., to any of the adjacent metal layers above or below. Accordingly, vias connect metal structures (e.g., metal lines or vias) from one metal layer to metal structures of an adjacent metal layer. While referred to as "metal" layers, various layers of the BEOL 1920, e.g., layers M0-Mn shown in FIG. 19, may include certain patterns of conductive metals, e.g., copper (Cu) or aluminum (Al), or metal alloys, or more generally, patterns of an electrically conductive material (e.g., including carbon based materials), formed in an insulating medium such as an interlayer dielectric (ILD). The insulating medium may include any suitable ILD materials such as silicon oxide, silicon nitride, aluminum oxide, and/or silicon oxynitride. In various embodiments, any one or more of these layers may additionally include active devices (e.g., transistors, diodes) and/or passive devices (e.g., capacitors, resistors, inductors).

The IC device 1900 may also include a backside 1940. For example, the backside 1940 may formed on the opposite side of a wafer from the front side 1930. In various embodiments, the backside 1940 may include any suitable elements to assist operation of the IC device 1900. For example, the backside 1940 may include various metal layers to deliver power to logic of the FEOL 1910.

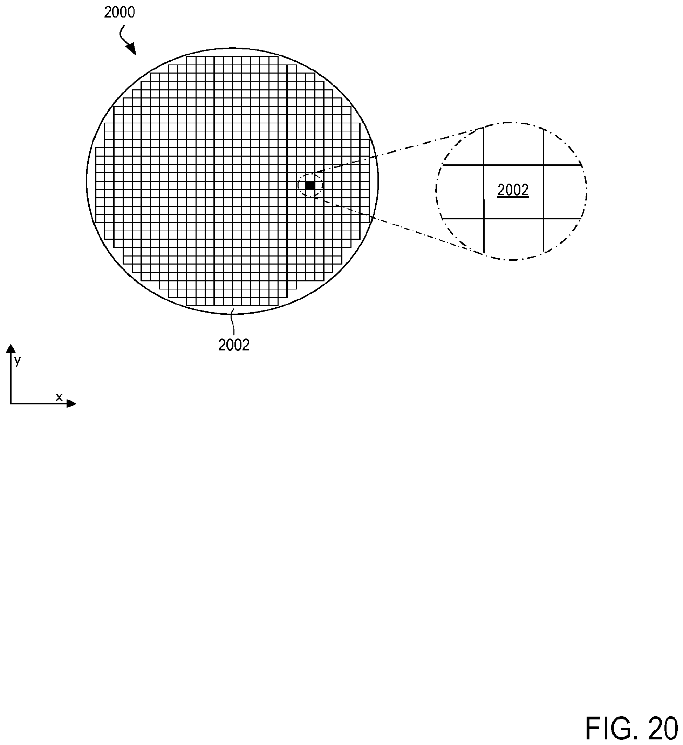

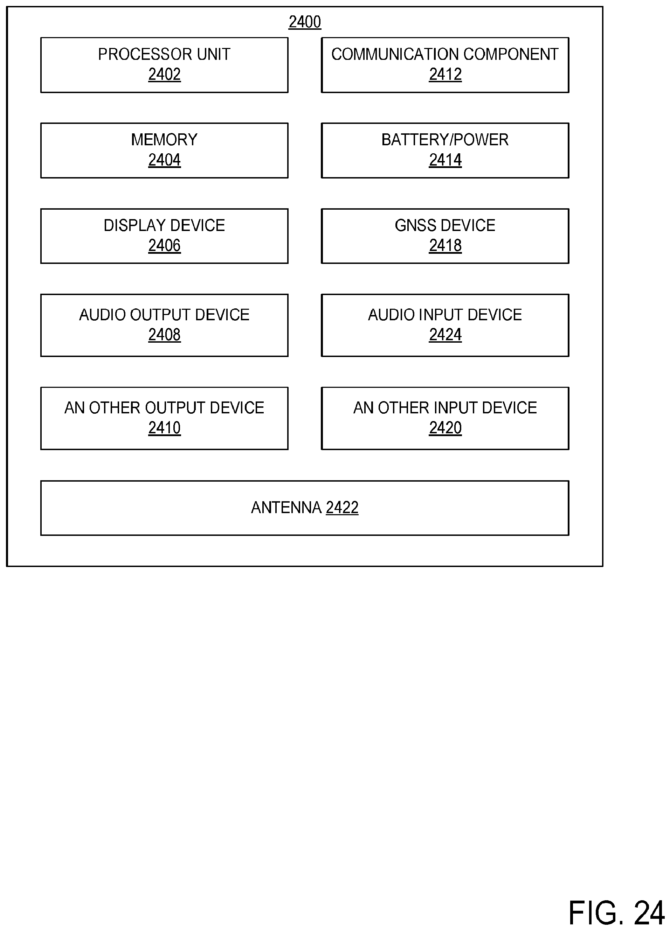

FIG. 20 is a top view of a wafer 2000 and dies 2002, wherein individual dies may be attached to a package substrate with a glass core or other structure(s) as disclosed herein. The wafer 2000 may be composed of semiconductor material and may include one or more dies 2002 having integrated circuit structures formed on a surface of the wafer 2000. The individual dies 2002 may be a repeating unit of an integrated circuit product that includes any suitable integrated circuit. After the fabrication of the semiconductor product is complete, the wafer 2000 may undergo a singulation process in which the dies 2002 are separated from one another to provide discrete "chips" of the integrated circuit product. The die 2002 may include one or more transistors, supporting circuitry to route electrical signals to the transistors, passive components (e.g., signal traces, resistors, capacitors, or inductors), and/or any other integrated circuit components. In some embodiments, the wafer 2000 or the die 2002 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 2002. For example, a memory array formed by multiple memory devices may be formed on a same die 2002 as a processor unit (e.g., the processor unit 2402 of FIG. 24) or other logic that is configured to store information in the memory devices or execute instructions stored in the memory array. In some embodiments, various ones of the microelectronic assemblies disclosed herein may be manufactured using a die-to-wafer assembly technique in which some dies are attached to a wafer 2000 that include other dies, and the wafer 2000 is subsequently singulated.

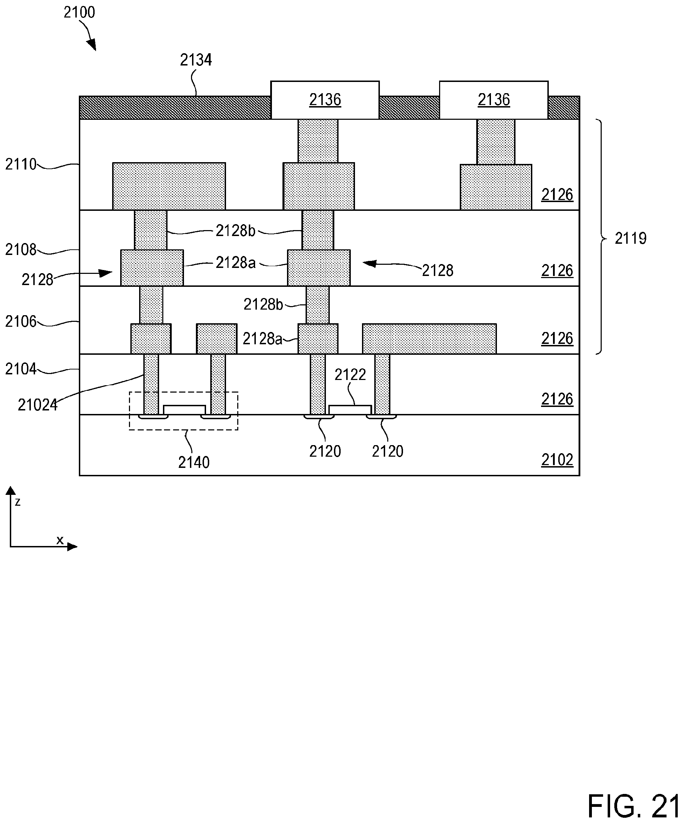

FIG. 21 is a cross-sectional side view of an integrated circuit device 2100 that may be attached to a substrate package with a glass core or other structure(s) as disclosed herein. One or more of the integrated circuit devices 2100 may be included in one or more dies 2002 (FIG. 20). The integrated circuit device 2100 may be formed on a die substrate 2102 (e.g., the wafer 2000 of FIG. 20) and may be included in a die (e.g., the die 2002 of FIG. 20). The die substrate 2102 may be a semiconductor substrate composed of semiconductor material systems including, for example, n-type or p-type materials systems (or a combination of both). The die substrate 2102 may include, for example, a crystalline substrate formed using a bulk silicon or a silicon-on-insulator (SOI) substructure. In some embodiments, the die substrate 2102 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 2102. Although a few examples of materials from which the die substrate 2102 may be formed are described here, any material that may serve as a foundation for an integrated circuit device 2100 may be used. The die substrate 2102 may be part of a singulated die (e.g., the dies 2002 of FIG. 20) or a wafer (e.g., the wafer 2000 of FIG. 20).

The integrated circuit device 2100 may include one or more device layers 2104 disposed on the die substrate 2102. The device layer 2104 may include features of one or more transistors 2140 (e.g., metal oxide semiconductor field-effect transistors (MOSFETs)) formed on the die substrate 2102. The transistors 2140 may include, for example, one or more source and/or drain (S/D) regions 2120, a gate 2122 to control current flow between the S/D regions 2120, and one or more S/D contacts 2124 to route electrical signals to/from the S/D regions 2120. The transistors 2140 may include additional features not depicted for the sake of clarity, such as device isolation regions, gate contacts, and the like. The transistors 2140 are not limited to the type and configuration depicted in FIG. 21 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

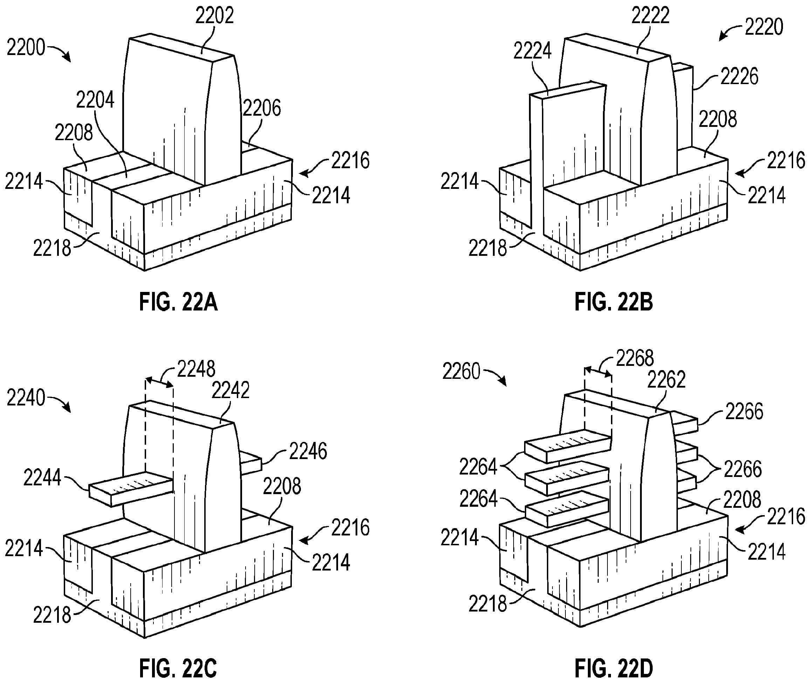

FIGS. 22A-22D are simplified perspective views of example planar, FinFET, gate-all-around, and stacked gate-all-around transistors. The transistors illustrated in FIGS. 22A-22D are formed on a substrate 2216 having a surface 2208. Isolation regions 2214 separate the source and drain regions of the transistors from other transistors and from a bulk region 2218 of the substrate 2216.

FIG. 22A is a perspective view of an example planar transistor 2200 comprising a gate 2202 that controls current flow between a source region 2204 and a drain region 2206. The transistor 2200 is planar in that the source region 2204 and the drain region 2206 are planar with respect to the substrate surface 2208.

FIG. 22B is a perspective view of an example FinFET transistor 2220 comprising a gate 2222 that controls current flow between a source region 2224 and a drain region 2226. The transistor 2220 is non-planar in that the source region 2224 and the drain region 2226 comprise "fins" that extend upwards from the substrate surface 2228. As the gate 2222 encompasses three sides of the semiconductor fin that extends from the source region 2224 to the drain region 2226, the transistor 2220 can be considered a tri-gate transistor. FIG. 22B illustrates one S/D fin extending through the gate 2222, but multiple S/D fins can extend through the gate of a FinFET transistor.

FIG. 22C is a perspective view of a gate-all-around (GAA) transistor 2240 comprising a gate 2242 that controls current flow between a source region 2244 and a drain region 2246. The transistor 2240 is non-planar in that the source region 2244 and the drain region 2246 are elevated from the substrate surface 2228.

FIG. 22D is a perspective view of a GAA transistor 2260 comprising a gate 2262 that controls current flow between multiple elevated source regions 2264 and multiple elevated drain regions 2266. The transistor 2260 is a stacked GAA transistor as the gate controls the flow of current between multiple elevated S/D regions stacked on top of each other. The transistors 2240 and 2260 are considered gate-all-around transistors as the gates encompass all sides of the semiconductor portions that extends from the source regions to the drain regions. The transistors 2240 and 2260 can alternatively be referred to as nanowire, nanosheet, or nanoribbon transistors depending on the width (e.g., widths 2248 and 2268 of transistors 2240 and 2260, respectively) of the semiconductor portions extending through the gate.

Returning to FIG. 21, a transistor 2140 may include a gate 2122 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 2140 is to be a p-type metal oxide semiconductor (PMOS) or an n-type metal oxide semiconductor (NMOS) transistor. In some implementations, the gate electrode may consist of or comprise a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 2140 along the source-channel-drain direction, the gate electrode may consist of or comprise a U-shaped structure that includes a bottom portion substantially parallel to the surface of the die substrate 2102 and two sidewall portions that are substantially perpendicular to the top surface of the die substrate 2102. In other embodiments, at least one of the metal layers that form the gate electrode may simply be a planar layer that is substantially parallel to the top surface of the die substrate 2102 and does not include sidewall portions substantially perpendicular to the top surface of the die substrate 2102. In other embodiments, the gate electrode may consist of or comprise a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 2120 may be formed within the die substrate 2102 adjacent to the gate 2122 of individual transistors 2140. The S/D regions 2120 may be formed using an implantation/diffusion process or an etching/deposition process, for example. In the former process, dopants such as boron, aluminum, antimony, phosphorous, or arsenic may be ion-implanted into the die substrate 2102 to form the S/D regions 2120. An annealing process that activates the dopants and causes them to diffuse farther into the die substrate 2102 may follow the ion-implantation process. In the latter process, the die substrate 2102 may first be etched to form recesses at the locations of the S/D regions 2120. An epitaxial deposition process may then be carried out to fill the recesses with material that is used to fabricate the S/D regions 2120. In some implementations, the S/D regions 2120 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 2120 may be formed using one or more alternate semiconductor materials such as germanium or a group III-V material or alloy. In further embodiments, one or more layers of metal and/or metal alloys may be used to form the S/D regions 2120.

Electrical signals, such as power and/or input/output (I/O) signals, may be routed to and/or from the devices (e.g., transistors 2140) of the device layer 2104 through one or more interconnect layers disposed on the device layer 2104 (illustrated in FIG. 21 as interconnect layers 2106-2110). For example, electrically conductive features of the device layer 2104 (e.g., the gate 2122 and the S/D contacts 2124) may be electrically coupled with the interconnect structures 2128 of the interconnect layers 2106-2110. The one or more interconnect layers 2106-2110 may form a metallization stack (also referred to as an "ILD stack") 2119 of the integrated circuit device 2100.

The interconnect structures 2128 (e.g., lines) may be arranged within the interconnect layers 2106-2110 to route electrical signals according to a wide variety of designs; in particular, the arrangement is not limited to the particular configuration of interconnect structures 2128 depicted in FIG. 21. Although a particular number of interconnect layers 2106-2110 is depicted in FIG. 21, embodiments of the present disclosure include integrated circuit devices having more or fewer interconnect layers than depicted.

In some embodiments, the interconnect structures 2128 may include lines 2128a and/or vias 2128b filled with an electrically conductive material such as a metal. The lines 2128a may be arranged to route electrical signals in a direction of a plane that is substantially parallel with a surface of the die substrate 2102 upon which the device layer 2104 is formed. For example, the lines 2128a may route electrical signals in a direction in and out of the page and/or in a direction across the page. The vias 2128b may be arranged to route electrical signals in a direction of a plane that is substantially perpendicular to the surface of the die substrate 2102 upon which the device layer 2104 is formed. In some embodiments, the vias 2128b may electrically couple lines 2128a of different interconnect layers 2106-2110 together.

The interconnect layers 2106-2110 may include a dielectric material 2126 disposed between the interconnect structures 2128, as shown in FIG. 21. In some embodiments, dielectric material 2126 disposed between the interconnect structures 2128 in different ones of the interconnect layers 2106-2110 may have different compositions; in other embodiments, the composition of the dielectric material 2126 between different interconnect layers 2106-2110 may be the same. The device layer 2104 may include a dielectric material 2126 disposed between the transistors 2140 and a bottom layer of the metallization stack as well. The dielectric material 2126 included in the device layer 2104 may have a different composition than the dielectric material 2126 included in the interconnect layers 2106-2110; in other embodiments, the composition of the dielectric material 2126 in the device layer 2104 may be the same as a dielectric material 2126 included in any one of the interconnect layers 2106-2110.

A first interconnect layer 2106 (referred to as Metal 1 or "M1") may be formed directly on the device layer 2104. In some embodiments, the first interconnect layer 2106 may include lines 2128a and/or vias 2128b, as shown. The lines 2128a of the first interconnect layer 2106 may be coupled with contacts (e.g., the S/D contacts 2124) of the device layer 2104. The vias 2128b of the first interconnect layer 2106 may be coupled with the lines 2128a of a second interconnect layer 2108.

The second interconnect layer 2108 (referred to as Metal 2 or "M2") may be formed directly on the first interconnect layer 2106. In some embodiments, the second interconnect layer 2108 may include via 2128b to couple the lines 2128 of the second interconnect layer 2108 with the lines 2128a of a third interconnect layer 2110. Although the lines 2128a and the vias 2128b are structurally delineated with a line within individual interconnect layers for the sake of clarity, the lines 2128a and the vias 2128b may be structurally and/or materially contiguous (e.g., simultaneously filled during a dual-damascene process) in some embodiments.

The third interconnect layer 2110 (referred to as Metal 3 or "M3") (and additional interconnect layers, as desired) may be formed in succession on the second interconnect layer 2108 according to similar techniques and configurations described in connection with the second interconnect layer 2108 or the first interconnect layer 2106. In some embodiments, the interconnect layers that are "higher up" in the metallization stack 2119 in the integrated circuit device 2100 (i.e., farther away from the device layer 2104) may be thicker that the interconnect layers that are lower in the metallization stack 2119, with lines 2128a and vias 2128b in the higher interconnect layers being thicker than those in the lower interconnect layers.

The integrated circuit device 2100 may include a solder resist material 2134 (e.g., polyimide or similar material) and one or more conductive contacts 2136 formed on the interconnect layers 2106-2110. In FIG. 21, the conductive contacts 2136 are illustrated as taking the form of bond pads. The conductive contacts 2136 may be electrically coupled with the interconnect structures 2128 and configured to route the electrical signals of the transistor(s) 2140 to external devices. For example, solder bonds may be formed on the one or more conductive contacts 2136 to mechanically and/or electrically couple an integrated circuit die including the integrated circuit device 2100 with another component (e.g., a printed circuit board). The integrated circuit device 2100 may include additional or alternate structures to route the electrical signals from the interconnect layers 2106-2110; for example, the conductive contacts 2136 may include other analogous features (e.g., posts) that route the electrical signals to external components.

In some embodiments in which the integrated circuit device 2100 is a double-sided die, the integrated circuit device 2100 may include another metallization stack (not shown) on the opposite side of the device layer(s) 2104. This metallization stack may include multiple interconnect layers as discussed above with reference to the interconnect layers 2106-2110, to provide conductive pathways (e.g., including conductive lines and vias) between the device layer(s) 2104 and additional conductive contacts (not shown) on the opposite side of the integrated circuit device 2100 from the conductive contacts 2136.

In other embodiments in which the integrated circuit device 2100 is a double-sided die, the integrated circuit device 2100 may include one or more through silicon vias (TSVs) through the die substrate 2102; these TSVs may make contact with the device layer(s) 2104, and may provide conductive pathways between the device layer(s) 2104 and additional conductive contacts (not shown) on the opposite side of the integrated circuit device 2100 from the conductive contacts 2136. In some embodiments, TSVs extending through the substrate can be used for routing power and ground signals from conductive contacts on the opposite side of the integrated circuit device 2100 from the conductive contacts 2136 to the transistors 2140 and any other components integrated into the integrated circuit device (e.g., die) 2100, and the metallization stack 2119 can be used to route I/O signals from the conductive contacts 2136 to transistors 2140 and any other components integrated into the integrated circuit device (e.g., die) 2100.

Multiple integrated circuit devices 2100 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

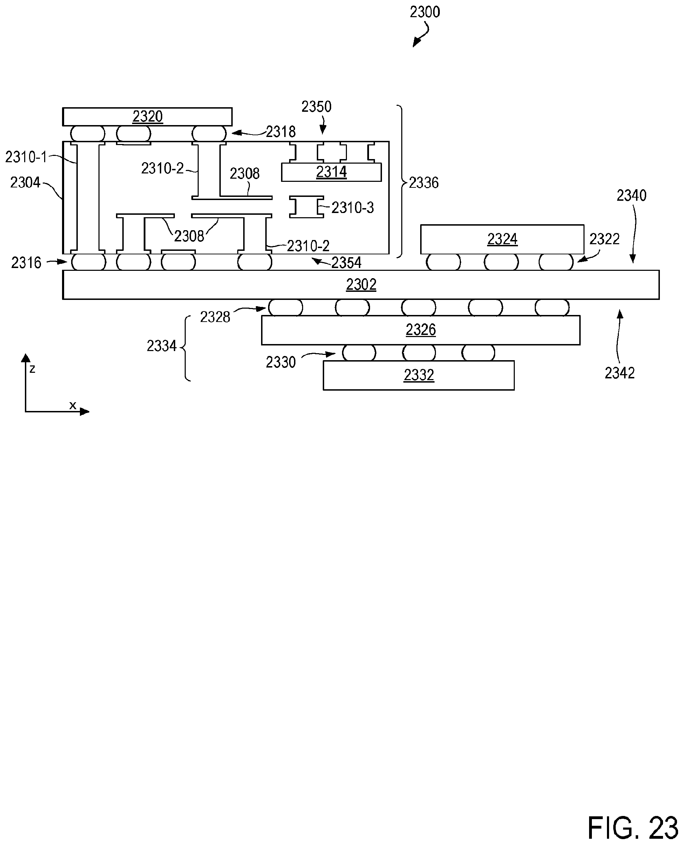

FIG. 23 is a cross-sectional side view of an integrated circuit device assembly 2300 that may include a substrate package with a glass core or other structure(s) as disclosed herein. In some embodiments, the integrated circuit device assembly 2300 may be a microelectronic assembly. The integrated circuit device assembly 2300 includes a number of components disposed on a circuit board 2302 (which may be a motherboard, system board, mainboard, etc.). The integrated circuit device assembly 2300 includes components disposed on a first face 2340 of the circuit board 2302 and an opposing second face 2342 of the circuit board 2302; generally, components may be disposed on one or both faces 2340 and 2342.

In some embodiments, the circuit board 2302 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 2302. In other embodiments, the circuit board 2302 may be a non-PCB substrate. The integrated circuit device assembly 2300 illustrated in FIG. 23 includes a package-on-interposer structure 2336 coupled to the first face 2340 of the circuit board 2302 by coupling components 2316. The coupling components 2316 may electrically and mechanically couple the package-on-interposer structure 2336 to the circuit board 2302, and may include solder balls (as shown in FIG. 23), pins (e.g., as part of a pin grid array (PGA), contacts (e.g., as part of a land grid array (LGA)), male and female portions of a socket, an adhesive, an underfill material, and/or any other suitable electrical and/or mechanical coupling structure.

The package-on-interposer structure 2336 may include an integrated circuit component 2320 coupled to an interposer 2304 by coupling components 2318. The coupling components 2318 may take any suitable form for the application, such as the forms discussed above with reference to the coupling components 2316. Although a single integrated circuit component 2320 is shown in FIG. 23, multiple integrated circuit components may be coupled to the interposer 2304; indeed, additional interposers may be coupled to the interposer 2304. The interposer 2304 may provide an intervening substrate used to bridge the circuit board 2302 and the integrated circuit component 2320.

The integrated circuit component 2320 may be a packaged or unpackaged integrated circuit product that includes one or more integrated circuit dies (e.g., the die 2002 of FIG. 20, the integrated circuit device 2100 of FIG. 21) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 2320, a single monolithic integrated circuit die comprises solder bumps attached to contacts on the die. The solder bumps allow the die to be directly attached to the interposer 2304. The integrated circuit component 2320 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 2320 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 2320 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 2320 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 2304 may spread connections to a wider pitch or reroute a connection to a different connection. For example, the interposer 2304 may couple the integrated circuit component 2320 to a set of ball grid array (BGA) conductive contacts of the coupling components 2316 for coupling to the circuit board 2302. In the embodiment illustrated in FIG. 23, the integrated circuit component 2320 and the circuit board 2302 are attached to opposing sides of the interposer 2304; in other embodiments, the integrated circuit component 2320 and the circuit board 2302 may be attached to a same side of the interposer 2304. In some embodiments, three or more components may be interconnected by way of the interposer 2304.

In some embodiments, the interposer 2304 may be formed as a PCB, including multiple metal layers separated from one another by layers of dielectric material and interconnected by electrically conductive vias. In some embodiments, the interposer 2304 may be formed of an epoxy resin, a fiberglass-reinforced epoxy resin, an epoxy resin with inorganic fillers, a ceramic material, or a polymer material such as polyimide. In some embodiments, the interposer 2304 may be formed of alternate rigid or flexible materials that may include the same materials described above for use in a semiconductor substrate, such as silicon, germanium, and other group III-V and group IV materials. The interposer 2304 may include metal interconnects 2308 and vias 2310, including but not limited to through hole vias 2310-1 (that extend from a first face 2350 of the interposer 2304 to a second face 2354 of the interposer 2304), blind vias 2310-2 (that extend from the first or second faces 2350 or 2354 of the interposer 2304 to an internal metal layer), and buried vias 2310-3 (that connect internal metal layers).

In some embodiments, the interposer 2304 can comprise a silicon interposer. Through silicon vias (TSV) extending through the silicon interposer can connect connections on a first face of a silicon interposer to an opposing second face of the silicon interposer. In some embodiments, an interposer 2304 comprising a silicon interposer can further comprise one or more routing layers to route connections on a first face of the interposer 2304 to an opposing second face of the interposer 2304.

The interposer 2304 may further include embedded devices 2314, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 2304. The package-on-interposer structure 2336 may take the form of any of the package-on-interposer structures known in the art.

The integrated circuit device assembly 2300 may include an integrated circuit component 2324 coupled to the first face 2340 of the circuit board 2302 by coupling components 2322. The coupling components 2322 may take the form of any of the embodiments discussed above with reference to the coupling components 2316, and the integrated circuit component 2324 may take the form of any of the embodiments discussed above with reference to the integrated circuit component 2320.

The integrated circuit device assembly 2300 illustrated in FIG. 23 includes a package-on-package structure 2334 coupled to the second face 2342 of the circuit board 2302 by coupling components 2328. The package-on-package structure 2334 may include an integrated circuit component 2326 and an integrated circuit component 2332 coupled together by coupling components 2330 such that the integrated circuit component 2326 is disposed between the circuit board 2302 and the integrated circuit component 2332. The coupling components 2328 and 2330 may take the form of any of the embodiments of the coupling components 2316 discussed above, and the integrated circuit components 2326 and 2332 may take the form of any of the embodiments of the integrated circuit component 2320 discussed above. The package-on-package structure 2334 may be configured in accordance with any of the package-on-package structures known in the art.

FIG. 24 is a block diagram of an example electrical device 2400 that may include a substrate package with a glass core or other structure(s) as disclosed herein. For example, any suitable components of the electrical device 2400 may include one or more of the integrated circuit device assemblies 2300, integrated circuit components 2320, integrated circuit devices 2100, integrated circuit dies 2002, or other components disclosed herein. A number of components are illustrated in FIG. 24 as included in the electrical device 2400, but any one or more of these components may be omitted or duplicated, as suitable for the application. In some embodiments, some or all of the components included in the electrical device 2400 may be attached to one or more motherboards mainboards, or system boards. In some embodiments, one or more of these components are fabricated onto a single system-on-a-chip (SoC) die.

Additionally, in various embodiments, the electrical device 2400 may not include one or more of the components illustrated in FIG. 24, but the electrical device 2400 may include interface circuitry for coupling to the one or more components. For example, the electrical device 2400 may not include a display device 2406, but may include display device interface circuitry (e.g., a connector and driver circuitry) to which a display device 2406 may be coupled. In another set of examples, the electrical device 2400 may not include an audio input device 2424 or an audio output device 2408, but may include audio input or output device interface circuitry (e.g., connectors and supporting circuitry) to which an audio input device 2424 or audio output device 2408 may be coupled.

The electrical device 2400 may include one or more processor units 2402 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 2402 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 2400 may include a memory 2404, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 2404 may include memory that is located on the same integrated circuit die as the processor unit 2402. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 2400 can comprise one or more processor units 2402 that are heterogeneous or asymmetric to another processor unit 2402 in the electrical device 2400. There can be a variety of differences between the processing units 2402 in a system in terms of a spectrum of metrics of merit including architectural, microarchitectural, thermal, power consumption characteristics, and the like. These differences can effectively manifest themselves as asymmetry and heterogeneity among the processor units 2402 in the electrical device 2400.

In some embodiments, the electrical device 2400 may include a communication component 2412 (e.g., one or more communication components). For example, the communication component 2412 can manage wireless communications for the transfer of data to and from the electrical device 2400. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 2412 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 2412 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 2412 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 2412 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 2412 may operate in accordance with other wireless protocols in other embodiments. The electrical device 2400 may include an antenna 2422 to facilitate wireless communications and/or to receive other wireless communications (such as amplitude modulation (AM) or frequency modulation (FM) radio transmissions).

In some embodiments, the communication component 2412 may manage wired communications, such as electrical, optical, or any other suitable communication protocols (e.g., IEEE 802.3 Ethernet standards). As noted above, the communication component 2412 may include multiple communication components. For instance, a first communication component 2412 may be dedicated to shorter-range wireless communications such as Wi-Fi or Bluetooth, and a second communication component 2412 may be dedicated to longer-range wireless communications such as global positioning system (GPS), EDGE, GPRS, CDMA, WiMAX, LTE, EV-DO, or others. In some embodiments, a first communication component 2412 may be dedicated to wireless communications, and a second communication component 2412 may be dedicated to wired communications.

The electrical device 2400 may include battery/power circuitry 2414. The battery/power circuitry 2414 may include one or more energy storage devices (e.g., batteries or capacitors) and/or circuitry for coupling components of the electrical device 2400 to an energy source separate from the electrical device 2400 (e.g., AC line power).

The electrical device 2400 may include a display device 2406 (or corresponding interface circuitry, as discussed above). The display device 2406 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 2400 may include an audio output device 2408 (or corresponding interface circuitry, as discussed above). The audio output device 2408 may include any embedded or wired or wirelessly connected external device that generates an audible indicator, such speakers, headsets, or earbuds.

The electrical device 2400 may include an audio input device 2424 (or corresponding interface circuitry, as discussed above). The audio input device 2424 may include any embedded or wired or wirelessly connected device that generates a signal representative of a sound, such as microphones, microphone arrays, or digital instruments (e.g., instruments having a musical instrument digital interface (MIDI) output). The electrical device 2400 may include a Global Navigation Satellite System (GNSS) device 2418 (or corresponding interface circuitry, as discussed above), such as a Global Positioning System (GPS) device. The GNSS device 2418 may be in communication with a satellite-based system and may determine a geolocation of the electrical device 2400 based on information received from one or more GNSS satellites, as known in the art.

The electrical device 2400 may include an other output device 2410 (or corresponding interface circuitry, as discussed above). Examples of the other output device 2410 may include an audio codec, a video codec, a printer, a wired or wireless transmitter for providing information to other devices, or an additional storage device.

The electrical device 2400 may include an other input device 2420 (or corresponding interface circuitry, as discussed above). Examples of the other input device 2420 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 2400 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 2400 may be any other electronic device that processes data. In some embodiments, the electrical device 2400 may comprise multiple discrete physical components. Given the range of devices that the electrical device 2400 can be manifested as in various embodiments, in some embodiments, the electrical device 2400 can be referred to as a computing device or a computing system.

Throughout this specification, plural instances may implement components, operations, or structures described as a single instance. Although individual operations of one or more methods are illustrated and described as separate operations, one or more of the individual operations may be performed concurrently, and nothing requires that the operations be performed in the order illustrated. Structures and functionality presented as separate components in example configurations may be implemented as a combined structure or component. Similarly, structures and functionality presented as a single component may be implemented as separate components. These and other variations, modifications, additions, and improvements fall within the scope of the subject matter herein.

It will also be understood that, although the terms "first," "second," and so forth may be used herein to describe various elements, these elements should not be limited by these terms. These terms are only used to distinguish one element from another, and are not intended to imply that the objects so described must be in a given sequence, either temporally, spatially, in ranking or in any other manner. For example, a first contact could be termed a second contact, and, similarly, a second contact could be termed a first contact, without departing from the scope of the present example embodiments. The first contact and the second contact are both contacts, but they are not the same contact.

As used in the description of the example embodiments and the appended examples, the singular forms "a," "an," and "the" are intended to include the plural forms as well, unless the context clearly indicates otherwise. It will also be understood that the term "and/or" as used herein refers to and encompasses any and all possible combinations of one or more of the associated listed items. For example, the phrase "A and/or B" means (A), (B), or (A and B), while the phrase "A, B, and/or C" means (A), (B), (C), (A and B), (A and C), (B and C), or (A, B, and C).

As used throughout this description, and in the claims, a list of items joined by the term "at least one of" or "one or more of" can mean any combination of the listed terms.

It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof. Furthermore, the terms "comprising," "including," "having," and the like, as used with respect to embodiments of the present disclosure, are synonymous.

The description may use the phrases "in an embodiment," "according to some embodiments," "in accordance with embodiments," or "in embodiments," which may each refer to one or more of the same or different embodiments.

As used herein, the term "module" refers to being part of, or including an ASIC, an electronic circuit, a system on a chip, a processor (shared, dedicated, or group), a solid state device, a memory (shared, dedicated, or group) that execute one or more software or firmware programs, a combinational logic circuit, and/or other suitable components that provide the described functionality.

As used herein, "electrically conductive" in some examples may refer to a property of a material having an electrical conductivity greater than or equal to 10⁷ Siemens per meter (S/m) at 20 degrees Celsius. Examples of such materials include Cu, Ag, Al, Au, W, Zn and Ni.

The term "signal" may refer to at least one current signal, voltage signal, magnetic signal, or data/clock signal.

Throughout the specification, and in the claims, the term "connected" means a direct connection, such as electrical, mechanical, or magnetic connection between the elements that are connected, without any intermediary devices. The term "coupled" means a direct or indirect connection, such as a direct electrical, mechanical, or magnetic connection between the elements that are connected or an indirect connection, through one or more passive or active intermediary devices.

The description may use perspective-based descriptions such as top/bottom, in/out, over/under, and the like. Such descriptions are merely used to facilitate the discussion and are not intended to restrict the application of embodiments described herein to any particular orientation.

The terms "over," "under," "between," and "on" as used herein refer to a relative position of one component or material with respect to other components or materials where such physical relationships are noteworthy. For example, in the context of materials, one material or layer over or under another may be directly in contact or may have one or more intervening materials or layers. Moreover, one material between two materials or layers may be directly in contact with the two materials/layers or may have one or more intervening materials/layers. In contrast, a first material or layer "on" a second material or layer means that at least a part of the first material or layer is in direct physical contact with at least a part of that second material/layer. Similar distinctions are to be made in the context of component assemblies.

As used herein, "A is proximate to B" may mean that A is adjacent to B or A is otherwise near to B.

Unless otherwise specified in the specific context of use, the term "predominantly" means more than 50%, or more than half. For example, a composition that is predominantly a first constituent means more than half of the composition (e.g., by volume) is the first constituent (e.g., >50 at. %). The term "primarily" means the most, or greatest, part. For example, a composition that is primarily a first constituent means the composition has more of the first constituent (e.g., by volume) than any other constituent. A composition that is primarily first and second constituents means the composition has more of the first and second constituents than any other constituent. The term "substantially" means there is only incidental variation. For example, composition that is substantially a first constituent means the composition may further include <1% of any other constituent. A composition that is substantially first and second constituents means the composition may further include <1% of any constituent substituted for either the first or second constituent.

The terms "substantially," "close," "approximately," "near," and "about," generally refer to being within +/- 10% of a target value (unless specifically specified).

Unless otherwise specified in the explicit context of their use, the terms "substantially equal," "about equal" or "approximately equal" mean that there is no more than incidental variation between two things so described. In the art, such variation is typically no more than +/-10% of a predetermined target value.

In the corresponding drawings of the embodiments, signals, currents, electrical biases, or magnetic or electrical polarities may be represented with lines. Some lines may be thicker, to indicate more constituent signal paths, and/or have arrows at one or more ends, to indicate primary information flow direction. Such indications are not intended to be limiting. Rather, the lines are used in connection with one or more exemplary embodiments to facilitate easier understanding of a circuit or a logical unit. Any represented signal, polarity, current, voltage, etc., as dictated by design needs or preferences, may actually comprise one or more signals that may travel in either direction and may be implemented with any suitable type of signal scheme.

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements.

Although the figures may illustrate embodiments where structures are substantially aligned to Cartesian axes (e.g., device structures having substantially vertical sidewalls), positive and negative (re-entrant) sloped feature sidewalls often occur in practice. For example, manufacturing non-idealities may cause one or more structural features to have sloped sidewalls. Thus, attributes illustrated are idealized merely for the sake of clearly describing salient features. It is to be understood that schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication.

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 includes an apparatus comprising a package substrate comprising a first layer comprising a photo-imageable dielectric (PID) material above the glass layer; a second layer below the glass layer, the second layer comprising the PID material; at least one buildup layer above the first layer; and at least one buildup layer below the second layer.

Example 2 includes the subject matter of Example 1, and wherein the first layer is on a top surface of the glass layer.

Example 3 includes the subject matter of any of Examples 1 and 2, and further including a third layer formed between the glass layer and the first layer.

Example 4 includes the subject matter of any of Examples 1-3, and wherein the third layer comprises silicon and nitrogen.

Example 5 includes the subject matter of any of Examples 1-4, and further including a fourth layer on the first layer, the fourth layer comprising a metal.

Example 6 includes the subject matter of any of Examples 1-5, and further including a metal via through the first layer layer and the glass layer.

Example 7 includes the subject matter of any of Examples 1-6, and further including an integrated circuit package comprising the package substrate, wherein the integrated circuit package comprises at least one integrated circuit die coupled to the package substrate.

Example 8 includes the subject matter of any of Examples 1-7, and further including at least one of a network interface, battery, or memory coupled to the integrated circuit die.

Example 9 includes the subject matter of any of Examples 1-8, and further including a printed circuit board coupled to the package substrate.

Example 10 includes the subject matter of any of Examples 1-9, and wherein the glass layer comprises a solid layer of glass rectangular in shape in plan view.

Example 11 includes the subject matter of any of Examples 1-10, and wherein the glass layer comprises silicon, oxygen, and aluminum.

Example 12 includes the subject matter of any of Examples 1-11, and wherein the layer of glass does not include an organic adhesive or an organic material.

Example 13 includes a system comprising an integrated circuit package comprising a package substrate comprising a glass layer; a first photo-imageable dielectric (PID) layer above the glass layer; a second PID layer below the glass layer; at least one buildup layer above the first PID layer; and at least one buildup layer below the second PID layer.

Example 14 includes the subject matter of Example 13, and wherein the first PID layer is on a top surface of the glass layer.

Example 15 includes the subject matter of any of Examples 13 and 14, and further including a material layer formed between the glass layer and the first PID layer.

Example 16 includes the subject matter of any of Examples 13-15, and wherein the material layer comprises silicon and nitrogen.

Example 17 includes the subject matter of any of Examples 13-16, and further including a metallic layer on the first PID layer.

Example 18 includes the subject matter of any of Examples 13-17, and further including a metal via through the first PID layer and the glass layer.

Example 19 includes the subject matter of any of Examples 13-18, and wherein the integrated circuit package comprises at least one integrated circuit die coupled to the package substrate.

Example 20 includes the subject matter of any of Examples 13-19, and further including at least one of a network interface, battery, or memory coupled to the integrated circuit die.

Example 21 includes the subject matter of any of Examples 13-20, and further including a printed circuit board coupled to the package substrate.

Example 22 includes the subject matter of any of Examples 13-21, and wherein the glass layer comprises a solid layer of glass rectangular in shape in plan view.

Example 23 includes the subject matter of any of Examples 13-22, and wherein the glass layer comprises silicon, oxygen, and aluminum.

Example 24 includes the subject matter of any of Examples 13-23, and wherein the layer of glass does not include an organic adhesive or an organic material.

Example 25 includes a method comprising a glass layer; forming a first photo-imageable dielectric (PID) layer above a glass layer; forming at least one buildup layer above the first PID layer; forming a second PID layer below the glass layer; and forming at least one buildup layer below the second PID layer.

Example 26 includes the subject matter of Example 25, and wherein the first PID layer and second PID layer are formed by laminating or coating a PID material on the glass layer.

Example 27 includes the subject matter of any of Examples 25 and 26, and wherein the first PID layer is on a top surface of the glass layer.

Example 28 includes the subject matter of any of Examples 25-27, and further including forming a material layer on the first PID layer, wherein the first PID layer is formed on the material layer.

Example 29 includes the subject matter of any of Examples 25-28, and wherein the material layer comprises silicon and nitrogen.

Example 30 includes the subject matter of any of Examples 25-29, and further including forming a metallic layer on the first PID layer.

Example 31 includes the subject matter of any of Examples 25-30, and further including forming a metal via through the first PID layer and the glass layer.

Example 32 includes the subject matter of any of Examples 25-31, and further including coupling at least one integrated circuit die to package substrate comprising the glass layer, first PID layer, second PID layer, the at least one buildup layer above the first PID layer, and the at least one buildup layer below the second PID layer.

Example 33 includes the subject matter of any of Examples 25-32, and further including coupling at least one of a network interface, battery, or memory coupled to the integrated circuit die.

Example 34 includes the subject matter of any of Examples 25-33, and further including coupling a printed circuit board to the package substrate.

Example 35 includes the subject matter of any of Examples 25-34, and wherein the glass layer comprises a solid layer of glass rectangular in shape in plan view.

Example 36 includes the subject matter of any of Examples 25-35, and wherein the glass layer comprises silicon, oxygen, and aluminum.

Example 37 includes the subject matter of any of Examples 25-36, wherein the glass layer does not include an organic adhesive or an organic material.

Example 38 includes an apparatus comprising an integrated circuit package substrate comprising a glass layer; an epoxy in contact with a first side of the glass layer; and at least one buildup layer over the glass layer and the epoxy.

Example 39 includes the subject matter of Example 38, and wherein the epoxy surrounds the glass layer in a horizontal plane.

Example 40 includes the subject matter of any of Examples 38 and 39, and wherein the epoxy comprises graphene.

Example 41 includes the subject matter of any of Examples 38-40, and wherein a volume of the epoxy that is graphene is between .01% and 5% of a total volume of the epoxy.

Example 42 includes the subject matter of any of Examples 38-41, and wherein a coefficient of thermal expansion of the epoxy is within a range of 2 - 12 parts per million change per degree Kelvin (ppm/K).

Example 43 includes the subject matter of any of Examples 38-42, and further including an integrated circuit package comprising the integrated circuit package substrate, wherein the integrated circuit package comprises at least one integrated circuit die coupled to the package substrate.

Example 44 includes the subject matter of any of Examples 38-43, and further including at least one of a network interface, battery, or memory coupled to the integrated circuit die.

Example 45 includes the subject matter of any of Examples 38-44, and further including a printed circuit board coupled to the package substrate.

Example 46 includes the subject matter of any of Examples 38-45, and wherein the glass layer comprises a solid layer of glass rectangular in shape in plan view.

Example 47 includes the subject matter of any of Examples 38-46, and wherein the glass layer comprises silicon, oxygen, and aluminum.

Example 48 includes the subject matter of any of Examples 38-47, and wherein the glass layer does not include an organic adhesive or an organic material.

Example 49 includes a system comprising an integrated circuit package substrate comprising a glass layer; an epoxy in contact with a first side of the glass layer; and at least one buildup layer over the glass layer and the epoxy.

Example 50 includes the subject matter of Example 49, and wherein the epoxy surrounds the glass layer in a horizontal plane.

Example 51 includes the subject matter of any of Examples 49 and 50, and wherein the epoxy comprises graphene.

Example 52 includes the subject matter of any of Examples 49-51, and wherein a volume of the epoxy that is graphene is between .01% and 5% of a total volume of the epoxy.

Example 53 includes the subject matter of any of Examples 49-52, and wherein a coefficient of thermal expansion of the epoxy is within a range of 2 - 12 parts per million change per degree Kelvin (ppm/K).

Example 54 includes the subject matter of any of Examples 49-53, and further including an integrated circuit package comprising the integrated circuit package substrate, wherein the integrated circuit package comprises at least one integrated circuit die coupled to the package substrate.

Example 55 includes the subject matter of any of Examples 49-54, and further including at least one of a network interface, battery, or memory coupled to the integrated circuit die.

Example 56 includes the subject matter of any of Examples 49-55, further comprising a printed circuit board coupled to the integrated circuit package substrate.

Example 57 includes the subject matter of any of Examples 49-56, and wherein the glass layer comprises a solid layer of glass rectangular in shape in plan view.

Example 58 includes the subject matter of any of Examples 49-57, and wherein the glass layer comprises silicon, oxygen, and aluminum.

Example 59 includes the subject matter of any of Examples 49-58, and wherein the layer of glass does not include an organic adhesive or an organic material.

Example 60 includes a method comprising forming at least a portion of an integrated circuit package substrate by forming a cavity in a glass panel; forming an epoxy in the cavity; and forming at least one buildup layer and the epoxy.

Example 61 includes the subject matter of Example 60, and wherein the epoxy surrounds the glass layer in a horizontal plane.

Example 62 includes the subject matter of any of Examples 60 and 61, and wherein the epoxy comprises graphene.

Example 63 includes the subject matter of any of Examples 60-62, and wherein a volume of the epoxy that is graphene is between .01% and 5% of a total volume of the epoxy.

Example 64 includes the subject matter of any of Examples 60-63, and wherein a coefficient of thermal expansion of the epoxy is within a range of 2 - 12 parts per million change per degree Kelvin (ppm/K).

Example 65 includes the subject matter of any of Examples 60-64, and further including coupling at least one integrated circuit die to the integrated circuit package substrate.

Example 66 includes the subject matter of any of Examples 60-65, and further including coupling at least one of a network interface, battery, or memory coupled to the integrated circuit die.

Example 67 includes the subject matter of any of Examples 60-66, and further including coupling a printed circuit board coupled to the integrated circuit package substrate.

Example 68 includes the subject matter of any of Examples 60-67, and wherein the glass layer comprises a solid layer of glass rectangular in shape in plan view.

Example 69 includes the subject matter of any of Examples 60-68, and wherein the glass layer comprises silicon, oxygen, and aluminum.

Example 70 includes the subject matter of any of Examples 60-69, wherein the glass layer does not include an organic adhesive or an organic material.

Example 71 includes an apparatus comprising a glass panel; a frame around a plurality of sides of the glass panel; and a reinforcement material comprising a polymer, wherein the reinforcement material is over a gap between the glass panel and the frame, wherein the gap is filled with material of at least one buildup layer.

Example 72 includes the subject matter of Example 71, and wherein the reinforcement material is in contact with a top surface of the frame and a top surface of the glass panel.

Example 73 includes the subject matter of any of Examples 71 and 72, and wherein the reinforcement material is on a buildup layer that is in contact with a top surface of the frame and a top surface of the glass panel.

Example 74 includes the subject matter of any of Examples 71-73, and wherein the polymer comprises fluorine and carbon.

Example 75 includes the subject matter of any of Examples 71-74, and wherein the polymer comprises a tape comprising polyimide or a film comprising polyethylene terephthalate.

Example 76 includes the subject matter of any of Examples 71-75, and wherein the gap between the frame and the glass panel is filled with a first buildup layer and a second buildup layer, wherein the first buildup layer has a different composition than the second buildup layer.

Example 77 includes the subject matter of any of Examples 71-76, and wherein the glass panel comprises a solid layer of glass rectangular in shape in plan view.

Example 78 includes the subject matter of any of Examples 71-77, and wherein the glass panel comprises silicon, oxygen, and aluminum.

Example 79 includes the subject matter of any of Examples 71-78, wherein the glass panel does not include an organic adhesive or an organic material.

Example 80 includes a method comprising positioning a glass panel within a frame; filling a gap between the glass panel and the frame with material of at least one buildup layer; and forming a reinforcement material over the gap, the reinforcement material comprising a polymer.

Example 81 includes the subject matter of Example 80, and further including forming the reinforcement material on a top surface of the frame and a top surface of the glass panel.

Example 82 includes the subject matter of any of Examples 80 and 81, and further including forming the reinforcement material on a buildup layer that is in contact with a top surface of the frame and a top surface of the glass panel.

Example 83 includes the subject matter of any of Examples 80-82, and wherein the polymer comprises fluorine and carbon.

Example 84 includes the subject matter of any of Examples 80-83, and wherein the reinforcement material comprises a tape comprising polyimide or a film comprising polyethylene terephthalate.

Example 85 includes the subject matter of any of Examples 80-84, and further including filling the gap between the frame and the glass panel with a first buildup layer and a second buildup layer, wherein the first buildup layer has a different composition than the second buildup layer.

Example 86 includes the subject matter of any of Examples 80-85, and wherein the glass panel comprises a solid layer of glass rectangular in shape in plan view.

Example 87 includes the subject matter of any of Examples 80-86, and wherein the glass panel comprises silicon, oxygen, and aluminum.

Example 88 includes the subject matter of any of Examples 80-87, and wherein the glass panel does not include an organic adhesive or an organic material.

Example 89 includes the subject matter of any of Examples 80-88, and further including singulating a panel assembly comprising the glass panel to form a plurality of units, wherein at least one of the plurality of units comprises a portion of the reinforcement material over a portion of the glass panel.

The foregoing description, for the purpose of explanation, has been described with reference to specific example embodiments. However, the illustrative discussions above are not intended to be exhaustive or to limit the possible example embodiments to the precise forms disclosed. Many modifications and variations are possible in view of the above teachings. The example embodiments were chosen and described in order to best explain the principles involved and their practical applications, to thereby enable others skilled in the art to best utilize the various example embodiments with various modifications as are suited to the particular use contemplated.

## Claims

1. An apparatus comprising:
a package substrate comprising:
a glass layer;
a first layer comprising a photo-imageable dielectric (PID) material above the glass layer;
a second layer below the glass layer, the second layer comprising the PID material;
at least one buildup layer above the first layer; and
at least one buildup layer below the second layer.

2. The apparatus of claim 1, wherein the first layer is on a top surface of the glass layer.

3. The apparatus of claim 1, further comprising a third layer formed between the glass layer and the first layer.

4. The apparatus of claim 3, wherein the third layer comprises silicon and nitrogen.

5. The apparatus of any one of claims 1-4, further comprising a fourth layer on the first layer, the fourth layer comprising a metal.

6. The apparatus of any one of claims 1-5, further comprising a metal via through the first layer and the glass layer.

7. The apparatus of any one of claims 1-6, further comprising an integrated circuit package comprising the package substrate, wherein the integrated circuit package comprises at least one integrated circuit die coupled to the package substrate.

8. The apparatus of claim 7, further comprising at least one of a network interface, battery, or memory coupled to the integrated circuit die.

9. The apparatus of any of claims 1-8, further comprising a printed circuit board coupled to the package substrate.

10. A method of forming the apparatus of any of claims 1-9.
